(19)

Europäisches
Patentamt
European
Patent Office
Office européen
des brevets

(11) **EP 2 387 080 A2**

(12) **EUROPEAN PATENT APPLICATION**

(43) Date of publication:
**16.11.2011 Bulletin 2011/46**

(51) Int Cl.:
***H01L 31/052*** (2006.01)

(21) Application number: **11164680.8**

(22) Date of filing: **03.05.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **11.05.2010 JP 2010109077**

(71) Applicant: **Sony Corporation Tokyo 108-0075 (JP)**

(72) Inventor: **Shimura, Jusuke Tokyo (JP)**

(74) Representative: **Malden, Nicholas D Young & Co LLP 120 Holborn London EC1N 2DY (GB)**

(54) **Photoelectric conversion device**

(57)    Photoelectric conversion elements having configurations suitable for various applications and related components, and methods associated therewith, are described. Photoelectric conversion elements may include electrodes and be arranged in association with a light collector such that light incident on one of the electrodes of a photoelectric conversion element is rendered uneven. In some cases, the electrodes may have current extraction regions where the light collector may direct light incident on the light collector toward one current extraction region in an amount greater than another current extraction region. Photoelectric conversion elements may be disposed adjacent to one another in a manner where a portion of one photoelectric conversion element may be electrically connected with a portion of an adjacent photoelectric conversion element. Photolectric conversion elements can also be arranged in a variety of suitable patterns.

FIG.1A

EP 2 387 080 A2

**Description**

The present disclosure relates to a photoelectric conversion device.

The solar cell such as a dye-sensitized solar cell has a photoelectric conversion element formed by stacking a first electrode, a photoelectric conversion layer, and a second electrode over a support substrate. The second electrode (e.g. negative electrode), on which light is incident, is normally formed of a transparent electrically-conductive film of e.g. indium-doped tin oxide (ITO) or fluorine-doped tin oxide (FTO), and the first electrode (e.g. positive electrode) is formed of e.g. platinum or carbon. The transparent electrically-conductive material used as the second electrode generally has high sheet resistance and power generation loss attributed to this resistance component has been a problem. The film thickness of the second electrode may be increased in order to reduce the power generation loss at the second electrode. However, excessively increasing the thickness of the second electrode leads to the lowering of the amount of light reaching the photoelectric conversion layer and hence a decrease in the electrical generating capacity. That is, a trade-off relationship exists.

To address such a problem, as the related art, there has been proposed a method in which a metal wire (bus bar) is provided in a grid manner on the surface of the second electrode to thereby decrease the resistance as the whole of the second electrode and enhance the power collection efficiency (refer to e.g. Japanese Patent Laid-open No. 2003-203681). However, such a method has a problem that the aperture ratio is sacrificed and therefore the lowering of the electrical generating capacity is caused.

There is a desire for the present disclosure to provide a photoelectric conversion device capable of achieving increase in the electrical generating capacity with reduction in power generation loss at an electrode.

In an illustrative embodiment, a photoelectric conversion element is provided. The photoelectric conversion element includes a first electrode; a second electrode; a photoelectric conversion layer disposed between the first electrode and the second electrode; and a light collector configured to direct light incident on the light collector such that light incident on the second electrode is rendered uneven.

In another illustrative embodiment, a photoelectric conversion element is provided. The photoelectric conversion element includes a first electrode having a first current extraction region; a second electrode having a second current extraction region; a photoelectric conversion layer disposed between the first electrode and the second electrode; and a light collector configured to direct light incident on the light collector toward the second current extraction region in an amount greater than the first current extraction region.

In a further illustrative embodiment, a photoelectric conversion device is provided. The photoelectric conversion device includes a plurality of photoelectric conversion elements including a first photoelectric conversion element disposed adjacent to a second photoelectric conversion element. Each photoelectric conversion element includes a first electrode having a first current extraction region; a second electrode having a second current extraction region; and a photoelectric conversion layer disposed between the first electrode and the second electrode. The photoelectric conversion device also includes a light collector disposed adjacent to the plurality of photoelectric conversion elements. For each photoelectric conversion element, the light collector is configured to direct light incident on the light collector toward the second current extraction region in an amount greater than the first current extraction region.

In another illustrative embodiment, a method of using a photoelectric conversion device is provided. The method includes providing a photoelectric conversion element. The photoelectric conversion element includes a first electrode having a first current extraction region, and a second electrode having a second current extraction region. The method of using the photoelectric conversion device further includes directing light toward the photoelectric conversion element such that a greater amount of light is directed toward the second current extraction region than the first current extraction region.

Further particular and preferred aspects of the present invention are set out in the accompanying independent and dependent claims. Features of the dependent claims may be combined with features of the independent claims as appropriate, and in combinations other than those explicitly set out in the claims.

The present invention will be described further, by way of example only, with reference to preferred embodiments thereof as illustrated in the accompanying drawings, in which :

FIGS. 1A and 1B are schematic sectional views of a photoelectric conversion device or a photoelectric conversion element module of a first embodiment, and an enlarged schematic partial sectional view of a light collector in the first embodiment, respectively;

FIG. 2 is a schematic plan view of a second electrode in the photoelectric conversion device or the photoelectric conversion element module of the first embodiment;

FIGS. 3A and 3B show pictures of the light collector in the first embodiment, and the equivalent circuit of one photoelectric conversion element in the first embodiment, respectively;

FIGS. 4A and 4B are a graph showing the light intensity distribution in one photoelectric conversion element in the first embodiment and a comparative example 1A, and a graph showing the results of simulations on the I-V characteristic of the photoelectric conversion element in the first embodiment and the comparative example 1A, respectively;

FIG. 5 is a graph showing the results of power generation tests in the first embodiment, a comparative example 1B, and a comparative example 1C;

FIGS. 6A, 6B, and 6C are schematic partial sectional views of a transparent substrate and so forth for explaining a manufacturing method for the photoelectric conversion device or the photoelectric conversion element module of the first embodiment;

FIG. 7 is a schematic sectional view of a photoelectric conversion device or a photoelectric conversion element module of a second embodiment;

FIG. 8 is a schematic plan view of a second electrode in the photoelectric conversion device or the photoelectric conversion element module of the second embodiment;

FIGS. 9A to 9C are schematic partial sectional views of a transparent substrate and so forth for explaining the outline of a manufacturing method for the photoelectric conversion device or the photoelectric conversion element module of the second embodiment;

FIG. 10 is a schematic sectional view of a photoelectric conversion device or a photoelectric conversion element module of a third embodiment;

FIG. 11 is a schematic sectional view of a photoelectric conversion device or a photoelectric conversion element module of a fourth embodiment;

FIG. 12 is a schematic plan view of the second electrode in a modification example of the photoelectric conversion device or the photoelectric conversion element module of the first embodiment to the fourth embodiment;

FIG. 13 is a schematic plan view of the second electrode in another modification example of the photoelectric conversion device or the photoelectric conversion element module of the first embodiment to the fourth embodiment;

FIG. 14 is a schematic plan view of the second electrode in another modification example of the photoelectric conversion device or the photoelectric conversion element module of the first embodiment to the fourth embodiment;

FIG. 15 is a schematic plan view of the second electrode in another modification example of the photoelectric conversion device or the photoelectric conversion element module of the first embodiment to the fourth embodiment;

FIG. 16 is a schematic plan view of the second electrode in another modification example of the photoelectric conversion device or the photoelectric conversion element module of the first embodiment to the fourth embodiment;

FIG. 17 is a conceptual diagram of the light collector of a Fresnel lens type;

FIG. 18 is a conceptual diagram showing a state in which light having uniform light intensity is incident on a lens equivalent to the light collector and is output from the lens with linearly inclined light intensity;

FIG. 19 is a schematic partial sectional view of the light collector for explaining how to obtain the outer shape line (lens surface shape) of the light collector; and

FIG. 20 is a schematic sectional view of a photoelectric conversion device of the comparative example 1B.

Embodiments described herein will be described below with reference to the drawings. However, the present disclosure is not limited to the embodiments and various numerical values and materials in the embodiments are examples. The order of the description is as follows.

1. Overall Description of a Photoelectric Conversion Device According to Some Embodiments
2. First Embodiment (Photoelectric Conversion Device and Photoelectric Conversion Element Module)
3. Second Embodiment (Modification of First Embodiment)
4. Third Embodiment (Another Modification of First Embodiment)
5. Fourth Embodiment (Further Another Modification of First Embodiment) and Others

[Overall Description of Some Embodiments of a Photoelectric Conversion Device]

Embodiments of a photoelectric conversion device can have a configuration in which a plurality of the photoelectric conversion elements are disposed and the light collector is disposed on the light incident side of each of the photoelectric conversion elements. Such a photoelectric conversion device will be often referred to as "the photoelectric conversion element module of the present disclosure" for convenience.

The photoelectric conversion element module of the present disclosure can have a form in which one end of the second electrode of one photoelectric conversion element is connected to the first electrode of another photoelectric conversion element adjacent to the one end,

the other end of the second electrode of the one photoelectric conversion element is insulated from the second electrode of another photoelectric conversion element adjacent to the other end, and

in the one photoelectric conversion element, light incident on the second electrode through the light collector is collected by the light collector more strongly onto part on a side on which an electrode having high electric resistance (electrode having low electrical conductivity) is connected to an electrode having low electric resistance (electrode having high electrical conductivity), included in the photoelectric conversion element adjacent to the one photoelectric conversion element.

Specifically, one end of the second electrode of one photoelectric conversion element is connected to the first electrode of another photoelectric conversion element adjacent to this one end. This one photoelectric conversion element will be referred to as "photoelectric conversion element-A" for convenience, and this another photoelectric conversion element will be referred to as "photoelectric conversion element-B" for convenience. Moreover, the other end of the second electrode of one photoelectric conversion element (photoelectric conversion element-A) is insulated from the second electrode of another photoelectric conversion element adjacent to the other end. This another photoelectric conversion element will be referred to as "photoelectric conversion element-C" for convenience. Furthermore, when the electric resistance of the first electrode is defined as $R_1$ and the electric resistance of the second electrode is defined as $R_2$, if a relationship $R_2 > R_1$ is satisfied, light is collected more strongly onto the area of photoelectric conversion element-A adjacent to photoelectric conversion element-B (vicinity of the current extraction area of the second electrode). Specifically, light is collected more strongly onto the area of photoelectric conversion element-A adjacent to photoelectric conversion element-B than onto the area of photoelectric conversion element-A adjacent to photoelectric conversion element-C. In contrast, if a relationship $R_2 < R_1$ is satisfied, light is collected more strongly onto the area of photoelectric conversion element-A adjacent to photoelectric conversion element-C (vicinity of the current extraction area of the first electrode). Specifically, light is collected more strongly onto the area of photoelectric conversion element-A adjacent to photoelectric conversion element-C than onto the area of photoelectric conversion element-A adjacent to photoelectric conversion element-B.

In the above-described preferred form, a configuration in which the second electrode corresponds to the electrode having high electric resistance and the first electrode corresponds to the electrode having low electric resistance can be employed. In this case, it is possible to employ a configuration in which light is collected more strongly onto the current extraction area side of the second electrode (vicinity of the current extraction area of the second electrode) (i.e. light is collected more strongly onto the current extraction area side of the second electrode than onto the current extraction area side of the first electrode). Moreover, it is possible to employ a configuration in which the height of an outer shape line of the light collector (on the basis of the light incident surface of the second electrode) when the light collector is cut by a virtual plane that passes through a current extraction area of the first electrode and a current extraction area of the second electrode and is perpendicular to the light incident surface of the second electrode increases in a direction from the current extraction area of the first electrode toward the current extraction area of the second electrode. That is, as the function of this outer shape line of the light collector, a function that increases monotonically and smoothly in the direction from the current extraction area of the first electrode toward the current extraction area of the second electrode can be employed. Furthermore, the following configuration can be employed. Specifically, a gap exists between one photoelectric conversion element (photoelectric conversion element-A) and another photoelectric conversion element (photoelectric conversion element-B) adjacent to the one photoelectric conversion element. In addition, an extension part of the light collector is disposed above the gap, and light passing through the extension part of the light collector reaches the one end side of the second electrode of the one photoelectric conversion element (photoelectric conversion element-A). In this case, it is possible to employ a configuration in which the height of an outer shape line of the extension part of the light collector (on the basis of the light incident surface of the second electrode) when the extension part of the light collector is cut by a virtual plane that passes through the current extraction area of the first electrode and the current extraction area of the second electrode and is perpendicular to the light incident surface of the second electrode decreases in such a direction as to get away from the current extraction area of the second electrode. That is, as the function of this outer shape line of the extension part of the light collector, a function that decreases monotonically and smoothly in such a direction as to get away from the current extraction area of the second electrode can be employed. Alternatively, it is also possible to employ a configuration in which the extension part of the light collector is disposed above the area adjacent to photoelectric conversion element-A and light passing through the extension part of the light collector reaches the second electrode of photoelectric conversion element-A. The outer shape line of the light collector may be an upwardly-convex curve. The outer shape line of the extension part of the light collector may be the combination of a downwardly convex curve, an upwardly-convex curve, and an upwardly-convex-and-concave curve. The above description corresponds to the case in which for example light is incident from the air on the light collector formed of a material whose refractive index surpasses 1 and is output from the light collector to be incident directly on the second electrode. For example if light is incident from the air on the light collector formed of a material whose refractive index surpasses 1 and is output from the light collector to be incident on a layer having a refractive index lower than the refractive index of the material of the light collector (e.g. air layer) and then incident on the second electrode, the height of the outer shape line of the light collector and the height of the outer shape line of the extension part of the light collector show changes opposite to the above-described changes. Furthermore, the function of the outer shape line of the light collector and the function of the outer shape line of the extension part of the light collector also show changes opposite to the above-described changes. Specifically, it is possible to employ a configuration in which the height of the outer shape line of the light collector decreases in the direction from the current extraction area of the first electrode toward the current extraction area of the second electrode. That is, as the function of this outer shape line of the light collector, a function that decreases monotonically and smoothly in the direction from the current extraction area of the first electrode toward the current extraction area of the second electrode can be employed. Furthermore, it is possible to employ a configuration in which the height of the outer shape line of the extension part of the light collector increases in such a direction as to get away from the current extraction area of the second electrode. That is, as the function of this outer shape line of the extension part of the light collector, a function that increases monotonically and smoothly in such a direction as to get away from the current extraction area of the second electrode can be employed. This point applies also to the photoelectric conversion device of the present disclosure to be described next.

The photoelectric conversion device of the present disclosure can have a form in which

when the electric resistance of the first electrode is defined as $R_1$ and the electric resistance of the second electrode is defined as $R_2$,

if a relationship $R_2 > R_1$ is satisfied, light incident on the second electrode is collected by the light collector more strongly onto the current extraction area side of the second electrode (i.e. light is collected more strongly onto the current extraction area side of the second electrode than onto the current extraction area side of the first electrode), and

if a relationship $R_1 > R_2$ is satisfied, light incident on the second electrode is collected by the light collector more strongly onto the current extraction area side of the first electrode (i.e. light is collected more strongly onto the current extraction area side of the first electrode than onto the current extraction area side of the second electrode). In this case, it is possible to employ a configuration in which the relationship $R_2 > R_1$ is satisfied and the height of an outer shape line of the light collector (on the basis of the light incident surface of the second electrode) when the light collector is cut by a virtual plane that passes through a current extraction area of the first electrode and a current extraction area of the second electrode and is perpendicular to the light incident surface of the second electrode increases in a direction from the current extraction area of the first electrode toward the current extraction area of the second electrode. That is, as the function of this outer shape line of the light collector, a function that increases monotonically and smoothly in the direction from the current extraction area of the first electrode toward the current extraction area of the second electrode can be employed. The outer shape line of the light collector may be an upwardly-convex curve.

Examples of the planar shape of the current extraction area of the first electrode and the current extraction area of the second electrode include circles, ellipses, shapes surrounded by arbitrary curves, rectangles, and polygons. Furthermore, examples of the planar shape of the current extraction area of the second electrode include combinations of rectangles (e.g. angulated C-character shape and L-character shape). The current extraction area of the first electrode is encompassed in the first electrode and can not be definitely discriminated in some cases. Similarly, the current extraction area of the second electrode is encompassed in the second electrode and can not be definitely discriminated in some cases.

The photoelectric conversion element module of the present disclosure including the above-described preferred forms and configurations can have a configuration in which a collector electrode is provided at the outer edge part of the second electrode. Furthermore, the photoelectric conversion device of the present disclosure including the above-described preferred forms and configurations can have a configuration in which a collector electrode is provided on the second electrode.

Moreover, the photoelectric conversion device or the photoelectric conversion element module of the present disclosure including the above-described preferred forms and configurations can have a form in which the light collector is formed of a lens or alternatively it is formed of a mirror, a prism, a hologram, or an optical waveguide. If the light collector is formed of a lens, a configuration in which the light collector has positive power (specifically, e.g. plano-convex lens or Fresnel lens) can be employed.

Furthermore, the photoelectric conversion device of the present disclosure including the above-described preferred forms and configurations can have a configuration in which the light collector prepared as a monolithic component for the plurality of the photoelectric conversion elements is disposed.

Hereinafter, the photoelectric conversion device of the present disclosure including the above-described preferred forms and configurations and the photoelectric conversion element module of the present disclosure including the above-described preferred forms and configurations will be often collectively referred to as "the photoelectric conversion device and so forth."

Examples of the material of the light collector in the photoelectric conversion device and so forth include glass including quartz glass and optical glass such as BK7, thermoplastic resins, and thermosetting resins. Examples of the thermoplastic resin include acrylic resin, polycarbonate resin, PMMA resin, "TOPAS," which is made by Polyplastics Co., Ltd. and is a polyolefin resin, amorphous polypropylene resin, polyester resin, polyurethane resin, polysulfone resin, polystyrene resin including AS resin, vinyl resin, halogen resin, and "ZEONOR," which is made by ZEON CORPORATION and is a norbornene polymer resin. Examples of the thermosetting resin include epoxy resin, polyimide resin, urea resin, phenolic resin, and silicone resin. If the light collector is formed from a thermoplastic resin, the light collector can be molded by an injection molding method. If the light collector is formed from a thermosetting resin, the light collector can be molded by a compression mold method or a transfer mold method. However, the molding method is not limited to these methods. The light collector prepared as a monolithic component for a plurality of photoelectric conversion elements may be fabricated based on any of these methods. Alternatively, it is also possible that the light collector is formed from an ultraviolet-curable resin. For assembling of the light collector and the photoelectric conversion device and so forth, the light collector is bonded to the photoelectric conversion element by using an adhesive for example. Alternatively, a method in which a resin layer to form the light collector is formed on the photoelectric conversion element and curing and shaping are performed may be employed. A method in which the resin layer is etched to thereby shape the resin layer may be employed.

There is no particular limitation to the base. For example, a glass substrate, a quartz substrate, a metal plate, or a plastic substrate to be described later can be used. Alternatively, as the base, a plastic film bonded to a transparent substrate to be described later can also be used. It is also possible to use a gas barrier film having oxygen permeability equal to or lower than 100 (cc/m$^2$/day/atm) and water vapor permeability equal to or lower than 100 (g/m$^2$/day). Specifically, it is also possible to use e.g. a gas barrier film obtained by stacking at least one kind of gas barrier material selected from the group including aluminum, silica, and alumina.

The material of the first electrode (counter electrode) may be any material as long as it is an electrically-conductive substance. However, it is also possible to employ an insulating substance as the material as long as an electrically-conductive catalyst layer is provided on the side of the first electrode opposed to the photoelectric conversion layer. Using an electrochemically stable material as the material of the first electrode is preferable. Specifically, it is preferable to use e.g. platinum (Pt) , gold (Au), ruthenium (Ru), iridium (Ir), carbon (C) such as carbon black, or an electrically-conductive polymer. If the photoelectric conversion layer is formed from e.g. a dye-sensitized semiconductor, a microstructure may be employed on the side of the first electrode opposed to the photoelectric conversion layer to thereby increase the surface area, for the purpose of enhancing the redox catalytic effect. If the first electrode is formed from e.g. platinum, achieving the platinum black state is preferable. If the first electrode is formed from carbon, achieving the porous state is preferable. The platinum black state can be achieved by e.g. anodization of platinum or reduction treatment of a platinum compound. The carbon in the porous state can be obtained by a method such as sintering of carbon microparticles or baking of an organic polymer. It is also possible to provide the transparent first electrode by wiring a metal having high redox catalytic effect, such as platinum, on a transparent base or by performing reduction treatment of a platinum compound on the surface.

It is also possible that the first electrode is formed from a foil that is formed of a metal or an alloy and has a catalyst layer on its single surface on the photoelectric conversion layer side or from a foil formed of a material having catalytic ability. Employing such a configuration can decrease the thickness of the first electrode and thus allows reduction in the thickness and weight of the photoelectric conversion device and so forth. The material of the foil formed of a metal or an alloy or the material having catalytic ability, for forming the first electrode, has a wide range of choice. There are no or few restrictions relating to the material of the first electrode. Furthermore, if the photoelectric conversion layer is separated from the first electrode by a porous insulating layer to be described later, adsorption of a constituent material of the photoelectric conversion layer (e.g. sensitizing dye) to the first electrode can be prevented, and thus characteristic deterioration hardly occurs. Examples of the foil formed of a metal or an alloy include a foil formed of a metal or an alloy containing at least one kind of element selected from the group including Ti, Ni, Cr, Fe, Nb, Ta, W, Co, and Zr. It is preferable that the catalyst layer provided on the single surface of the foil formed of a metal or an alloy on the photoelectric conversion layer side or the material having catalytic ability contain at least one kind of element selected from the group including Pt, Ru, Ir, and C. In terms of reduction in the thickness of the photoelectric conversion device and so forth, it is preferable that the thickness of the first electrode, i.e. the total thickness of the foil formed of a metal or an alloy and the catalyst layer or the thickness of the foil formed of the material having catalytic ability, be equal to or smaller than 0.1 mm. Examples of the method for forming the catalyst layer on the foil formed of a metal or an alloy include a wet-type method of applying a solution containing a catalyst or a precursor of a catalyst and dry-type methods such as physical vapor deposition (PVD) typified by e.g. sputtering and vacuum evaporation and various kinds of chemical vapor deposition (CVD).

The second electrode can be formed from a transparent electrically-conductive material. It is preferable that the surface resistance (sheet resistance) of the second electrode be as low as possible. Specifically, the surface resistance of the second electrode is preferably equal to or lower than 500 $\Omega/\square$ and more preferably equal to or lower than 100 $\Omega/\square$. The second electrode can be formed from a publicly-known material. Specific examples of the material include, but not limited to, indium-tin composite oxides (including indium tin oxide (ITO), Sn-doped $In_2O_3$, crystalline ITO, and amorphous ITO), fluorine-doped $SnO_2$ (FTO), IFO (F-doped $In_2O_3$), antimony-doped $SnO_2$ (ATO), $SnO_2$, ZnO (including Al-doped ZnO and B-doped ZnO) , indium-zinc composite oxides (indium zinc oxide (IZO)), spinel-type oxides, and oxides having the $YbFe_2O_4$ structure. Using two or more kinds of these materials in combination is also possible. It is preferable that the second electrode be covered by the transparent substrate. Patterning of the second electrode may be performed before the photoelectric conversion layer and so forth is stacked, or patterning of the second electrode may be performed after the photoelectric conversion layer and so forth is stacked. The patterning can be performed by publicly-known various kinds of etching methods, laser scribing, physical polishing processing, etc.

There is no particular limitation to the material of the transparent substrate. Any of various substrates can be used as long as it is transparent. It is preferable that the transparent substrate be formed from a material that is excellent in blocking ability against water and gas coming from the external, anti-solvent ability, and weatherability. Specific examples of the transparent substrate include transparent inorganic substrates of quartz, sapphire, and glass, and transparent plastic substrates of polyethylene terephthalate, polyethylene naphthalate, polycarbonate, polystyrene, polyethylene, polypropylene, polyphenylene sulfide, polyvinylidene fluoride, tetraacetyl cellulose, phenoxy bromide, aramids, polyimides, polystyrenes, polyarylates, polysulfones, and polyolefins. It is preferable to use, among these substrates, a substrate exhibiting high transmittance in the visible light region particularly. However, the transparent substrate is not limited thereto. In view of workability, reduction in the weight, etc., using a transparent plastic substrate as the transparent substrate is preferable. The thickness of the transparent substrate is not particularly limited and can be arbitrarily selected based on e.g. the light transmittance and the ability of blocking between the inside and outside of the photoelectric conversion element. If the base is formed from a plastic film, the base can be arbitrarily selected from a plastic film (transparency is unnecessary) composed of a material to form the above-described transparent plastic substrate.

The first electrode and the second electrode may be connected directly to each other, or may be connected to each other via a connecting part formed of an electrically-conductive material. In the latter case, specifically, the first electrode and the second electrode are connected to each other by e.g. an electrically-conductive adhesive. Alternatively, they are connected to each other by a low-melting-point metal or alloy having a melting point equal to or lower than 300°C. As the electrically-conductive adhesive, commercially available silver paste, carbon paste, nickel paste, copper paste, etc. can be used. Using an anisotropic electrically-conductive adhesive or an anisotropic electrically-conductive film is also possible. Furthermore, various kinds of low-melting-point metal or alloy that can be bonded to the second electrode, such as In and In-Sn solder, can also be used. Alternatively, the first electrode and the second electrode may be connected to each other by a collector electrode as described later. If the connecting part between the first electrode and the second electrode is in direct contact with an electrolyte, it is preferable to prevent the contact with the electrolyte by protecting the connecting part by e.g. resin.

The photoelectric conversion layer can be formed from e.g. a dye-sensitized semiconductor. However, the photoelectric conversion layer is not limited thereto. For example, it is also possible to employ a photoelectric conversion layer to configure a photoelectric conversion element such as a silicon-based solar cell.

If the photoelectric conversion layer is formed from a dye-sensitized semiconductor, typically the photoelectric conversion layer is formed of semiconductor microparticles carrying a sensitizing dye. Examples of the material of the semiconductor microparticles include semiconductor materials typified by silicon (Si), various kinds of compound semiconductor materials, and compounds having the perovskite structure. It is preferable that these semiconductors are n-type semiconductors in which conduction band electrons serve as carriers under light excitation and give an anode current. Specific examples of these semiconductors include $TiO_2$, ZnO, $WO_3$, $Nb_2O_5$, $TiSrO_3$, $SnO_2$, $ZrO_2$, $In_2O_3$, $La_2O_3$, $Ta_2O_5$, $BaTiO_3$, and CdS. Among them, anatase-type $TiO_2$ is particularly preferable. However, the semiconductor is not limited to these substances. Using two or more kinds of these substances as a mixture is also possible. The semiconductor microparticles can take various shapes and forms, such as particle shape, tube shape, and bar shape, according to need. There is no particular limitation to the particle diameter of the semiconductor microparticles. The average particle diameter of the primary particle is preferably $1 \times 10^{-9}$ m to $2 \times 10^{-7}$ m and particularly preferably $5 \times 10^{-9}$ m to $1 \times 10^{-7}$ m. It is also possible that the semiconductor microparticles having such an average particle diameter are mixed with semiconductor microparticles having a larger average particle diameter and incident light is scattered by the semiconductor microparticles having the larger average particle diameter to thereby increase the quantum yield. In this case, it is preferable that the average particle diameter of the semiconductor microparticles having the larger average particle diameter be $2 \times 10^{-8}$ m to $5 \times 10^{-7}$ m.

There is no particular limitation to the forming method for the photoelectric conversion layer (dye-sensitized semiconductor layer) formed of semiconductor microparticles. However, a wet film deposition method is preferable in view of the properties, convenience, the manufacturing cost, etc. Specifically, it is preferable to use a method in which a paste is prepared by evenly dispersing powder or sol of semiconductor microparticles in a solvent such as water or an organic solvent and applied on the second electrode. The applying method is not particularly limited and the applying can be performed in accordance with a publicly-known method. Examples of the applying method include dip method, spray method, wire bar method, spin-coating method, roller-coating method, blade-coating method, gravure-coating method, and printing method. As the printing method, various methods such as relief printing method, offset printing method, gravure printing method, intaglio printing method, rubber plate printing method, and screen printing method are available. If a crystalline titanium oxide is used as the semiconductor microparticles, it is preferable that the crystal type be the anatase type as described above in terms of photocatalytic activity. The anatase-type titanium oxide can be obtained in the form of commercially available powder, sol, or slurry. Alternatively, it is also possible to obtain the anatase-type titanium oxide having a predetermined particle diameter by a publicly-known method such as a method of hydrolyzing titanium oxide alkoxide. If commercially available powder is used, resolving the secondary aggregation of the particles is preferable, and it is preferable to disperse the particles by using mortar, ball mill, ultrasonic dispersing device, etc. in the preparation of the application liquid. At this time, in order to prevent the particles whose secondary aggregation is resolved from aggregating again, acetylacetone, hydrochloric acid, nitric acid, surfactant, chelating agent, etc. is added. Furthermore, for increasing the viscosity, any of various kinds of thickeners may be added. Examples of the thickeners include polymers such as polyethylene oxide and polyvinyl alcohol and cellulose-based thickeners.

In the photoelectric conversion layer (dye-sensitized semiconductor layer) that is composed of semiconductor microparticles and formed from a dye-sensitized semiconductor, it is preferable that the semiconductor microparticles be particles having a large surface area so that many sensitizing dyes can adsorb to the semiconductor microparticles. Specifically, it is preferable that the surface area of the photoelectric conversion layer in the state in which the semiconductor microparticles are formed on a support body (e.g. second electrode) be equal to or larger than $1 \times 10^1$ times the projected area, and it is more preferable that the surface area be equal to or larger than $1 \times 10^2$ times the projected area. The upper limit of the surface area is not particularly limited and is normally about $1 \times 10^3$ times the projected area. In general, as the thickness of the photoelectric conversion layer composed of semiconductor microparticles increases, the amount of carried sensitizing dyes per unit projected area increases and thus the light capture rate becomes higher. However, because the diffusion distance of electrons increases, loss due to charge recombination also becomes larger. Therefore, a preferred thickness exists for the photoelectric conversion layer. This thickness is generally $1 \times 10^{-7}$ m to $1 \times 10^{-4}$ m. Furthermore, a thickness in the range of $1 \times 10^{-6}$ m to $5 \times 10^{-5}$ m is more preferable and a thickness in the range of $3 \times 10^{-6}$ m to $3 \times 10^{-5}$ m is particularly preferable. It is preferable that the photoelectric conversion layer composed of semiconductor microparticles be baked after being applied on the support body in order to bring the particles into contact with each other electronically and enhance the film strength and the adhesiveness to the support body. There is no particular limitation to the range of the baking temperature. However, too high a baking temperature possibly leads to high resistance of the support body and melting. Therefore, the baking temperature is normally 40°C to 700°C and preferably 40°C to 650°C. The baking time is also not particularly limited and is normally 10 minutes to 10 hours. After the baking, e.g. chemical plating treatment with use of an aqueous solution of titanium tetrachloride, necking treatment with use of an aqueous solution of titanium trichloride, and dip treatment with sol of semiconductor ultra-microparticles having a diameter equal to or smaller than 10 nm may be performed for the purpose of increasing the surface area of the photoelectric conversion layer composed of semiconductor microparticles and enhancing necking among the semiconductor microparticles. If a plastic substrate is used as the transparent substrate, it is also possible to apply a paste containing a binder on the transparent substrate and perform pressure bonding to the transparent substrate by heating press.

The sensitizing dye carried by the photoelectric conversion layer (dye-sensitized semiconductor layer) is not particularly limited as long as it exhibits sensitization action. Examples of the sensitizing dye include xanthene dyes such as rhodamine B, rose bengal, eosin, and erythrosine, cyanine dyes such as merocyanine, quinocyanine, and cryptocyanine, basic dyes such as phenosafranine, Capri blue, thiocine, and methylene blue, and porphyrin compounds such as chlorophyll, zinc porphyrin, and magnesium porphyrin. Furthermore, the examples further include azo dye, phthalocyanine compounds, coumarin compounds, Ru bipyridine complex compounds, Ru terpyridine complex compounds, anthraquinone dye, polycyclic quinine dye, and squarylium. Among them, Ru bipyridine complex compounds have a high quantum yield and thus are particularly preferable. However, the sensitizing dye is not limited to these substances. Using two or more kinds of these sensitizing dyes as a mixture is also possible.

There is no particular limitation to the method for adsorbing the sensitizing dye to the photoelectric conversion layer (dye-sensitized semiconductor layer). Examples of the adsorption method include a method in which the sensitizing dye is dissolved in a solvent such as alcohols, nitriles, nitromethane, halogenated hydrocarbon, ethers, dimethyl sulfoxide, amides, N-methylpyrrolidone, 1,3-dimethylimidazolidinone, 3-methyloxazolidinone, esters, carbonate esters, ketones, hydrocarbons, or water and the photoelectric conversion layer is immersed in this solution. Furthermore, the examples of the adsorption method include a method in which a sensitizing dye solution is applied on the photoelectric conversion layer. If a sensitizing dye having a high acidity is used, e.g. deoxycholic acid may be added for the purpose of reducing association among sensitizing dye molecules. After the adsorption of the sensitizing dye, treatment of the surface may be performed by using amines for the purpose of promoting removal of the excessively adsorbed sensitizing dye. Examples of the amines include pyridine, 4-tert-butylpyridine, and polyvinyl pyridine. If these substances are a liquid, they may be used as they are, or may be used after being dissolved in an organic solvent.

A porous insulating layer may be provided between the photoelectric conversion layer and the first electrode. The material of the porous insulating layer is not particularly limited as long as it is a material having no electrical conductivity. In particular, it is preferable to use an oxide containing at least one kind of element selected from the group including Zr, Al, Ti, Si, Zn, W, and Nb, and it is more preferable to use e.g. zirconia, alumina, titania, or silica among the oxides. Typically, microparticles of any of these oxides are used. It is preferable that the porosity of the porous insulating layer be equal to or higher than 10%. Although there is no limitation to the upper limit of the porosity, an upper limit of about 80% is preferable in view of the physical strength of the porous insulating layer. Porosity lower than 10% possibly affects the diffusion of the electrolyte and significantly lowers the characteristics of the photoelectric conversion device and so forth. Furthermore, it is preferable that the pore diameter of this porous insulating layer be 1 nm to 1 $\mu$m. A pore diameter smaller than 1 nm possibly affects the diffusion of the electrolyte and impregnation of the sensitizing dye and lowers the characteristics of the photoelectric conversion device and so forth. On the other hand, a pore diameter larger than 1 $\mu$m causes a possibility that catalyst particles of the first electrode enter the porous insulating layer and short-circuiting occurs. Although there is no limitation to the manufacturing method for the porous insulating layer, using a sintered body of the above-described oxide particles is preferable.

Typically, an electrolyte layer is provided between the photoelectric conversion layer (dye-sensitized semiconductor layer) and the first electrode (counter electrode). However, the photoelectric conversion layer and the first electrode may be impregnated with an electrolyte. If a porous insulating layer is provided between the photoelectric conversion layer and the first electrode, the porous insulating layer may also be impregnated with the electrolyte. Examples of the electrolyte include the combination of iodine ($I_2$) and a metal iodide or an organic iodide and the combination of bromine ($Br_2$) and a metal bromide or an organic bromide. Furthermore, the examples of the electrolyte include metal complexes such as ferrocyanic acid salt/ferricyanic acid salt and ferrocene/ferricinium ion, sulfur compounds such as poly(sodium sulfide) and alkyl thiol/alkyl disulfide, viologen dye, and hydroquinone/quinone. As the cation of the above-described metal compound, e.g. Li, Na, K, Mg, Ca, and Cs are preferable. As the cation of the above-described organic compound, quaternary ammonium compounds such as tetraalkyl ammoniums, pyridiniums, and imidazoliums are preferable. However, the electrolyte is not limited to these substances. Using two or more kinds of these substances as a mixture is also possible. Among them, an electrolyte obtained by combining $I_2$ and LiI, NaI, or a quaternary ammonium compound such as imidazolium iodide is preferable. The concentration of the electrolyte salt with respect to the solvent is preferably 0.05 mol to 5 mol and more preferably 0.2 mol to 3 mol. The concentration of $I_2$ or $Br_2$ is preferably 0.0005 mol to 1 mol and more preferably 0.001 mol to 0.3 mol. Furthermore, for the purpose of enhancing the open voltage $V_{oc}$, an additive agent formed of an amine compound typified by 4-tert-butylpyridine may be added.

Examples of the solvent to form the electrolyte composition include water, alcohols, ethers, esters, carbonate esters, lactones, carboxylic esters, phosphate triesters, heterocyclic compounds, nitriles, ketones, amides, nitromethane, halogenated hydrocarbon, dimethyl sulfoxide, sulfolane, N-methylpyrrolidone, 1,3-dimethylimidazolidinone, 3-methyloxazolidinone, and hydrocarbons. However, the solvent is not limited to these substances. Using two or more kinds of these substances as a mixture is also possible. Furthermore, it is also possible to use an ionic liquid of tetraalkyl-based, pyridinium-based, or imidazolium-based quaternary ammonium salt as the solvent.

It is also possible to dissolve gellant, polymer, cross-linked monomer, etc. in the electrolyte composition or disperse inorganic ceramic particles in the electrolyte composition to use it as a gel electrolyte in order to reduce liquid leakage and volatilization of the electrolyte. As for the ratio of the electrolyte composition to the gel matrix, if the amount of electrolyte composition is large, the mechanical strength is lowered although the ionic conductivity is high. In contrast, if the amount of electrolyte composition is too small, the ionic conductivity is lowered although the mechanical strength is high. Thus, the ratio of the electrolyte composition is preferably 50 wt.% to 99 wt.% with respect to the gel electrolyte and more preferably 80 wt.% to 97 wt.%. Furthermore, it is also possible to realize an all-solid-state photoelectric conversion device and so forth by dissolving the electrolyte and a plasticizer in a polymer and removing the plasticizer by volatilization.

If the photoelectric conversion element is formed from a dye-sensitized photoelectric conversion element, the manufacturing method for the photoelectric conversion element is not particularly limited. However, in view of the thicknesses of the respective layers, the productivity, the pattern accuracy, etc., it is preferable that the respective layers except the second electrode be formed by a screen printing method or a coating method such as a spray coating method, and it is particularly preferable to form the layers by a screen printing method. It is preferable that the photoelectric conversion layer and the porous insulating layer be formed through coating and baking of pastes containing the particles for forming the respective layers. The porosity of each layers is determined by the ratio of the binder component to the particles in the paste. It is preferable that the first electrode be also formed through coating and baking of a paste similarly. However, if adsorption of the material of the photoelectric conversion layer (e.g. sensitizing dye) to the first electrode affects the characteristics, the sensitizing dye is adsorbed to the photoelectric conversion layer at the timing when layers to the photoelectric conversion layer and the porous insulating layer have been formed, and thereafter the first electrode is formed on the porous insulating layer. If the first electrode is formed by providing a catalyst layer on the single surface of a foil formed of a metal or an alloy on the porous insulating layer side, the catalyst layer on the foil formed of a metal or an alloy is oriented toward the porous insulating layer side and bonded to the second electrode of an adjacent photoelectric conversion element. Filling with the electrolyte for impregnating the photoelectric conversion layer, the porous insulating layer, and so forth with the electrolyte can be performed by e.g. a method of using a dispenser or a printing method including an ink-jet printing method. The photoelectric conversion element module obtained by connecting plural photoelectric conversion elements in series involves a possibility that short-circuiting between the photoelectric conversion elements occurs due to the leakage of the electrolyte. Therefore, it is not preferable to add the electrolyte whose amount is larger than the amount of electrolyte with which the photoelectric conversion layer, the porous insulating layer, and so forth of the respective photoelectric conversion elements are impregnated.

Furthermore, for example, it is possible that the electrolyte composition is in a liquid state or is gelatinized inside the photoelectric conversion element. In addition, if it is in a liquid state before the introduction, the parts of the transparent substrate and the base on which the photoelectric conversion layer is not formed can be sealed, with the photoelectric conversion layer and the first electrode oriented toward each other. The distance between the photoelectric conversion layer and the first electrode is not particularly limited and is normally 1 $\mu$n to 100 $\mu$m and more preferably 1 $\mu$m to 50 $\mu$m. If this distance is too long, possibly the photocurrent decreases due to the lowering of the electrical conductivity. Although the sealant is not particularly limited, it is preferable to use a material having weatherability, insulating ability, and moisture resistance. Examples of the sealant include epoxy resin, ultraviolet-curable resin, acrylic adhesive, ethylene vinyl acetate (EVA), ionomer resin, ceramic, and various kinds of heat sealing films. Furthermore, various welding methods can be used. The method for the subsequent injection of the solution of the electrolyte composition is also not particularly limited. However, it is preferable to employ a method in which the outer peripheral part is sealed in advance and the solution is injected under reduced pressure into the inside of the photoelectric conversion element for which a solution inlet is opened. In this case, a method in which several drops of the solution are placed into the inlet and the solution is injected by capillary action is easy. Furthermore, it is also possible to carry out the operation of the solution injection under reduced pressure or heating according to need. After the solution is completely injected, the solution left around the inlet is removed and the inlet is sealed. This sealing method is also not particularly limited and the inlet can be sealed by bonding a glass plate or a plastic substrate by a sealant according to heed. Besides this method, it is also possible to employ a method in which the electrolyte is dropped and sealing is performed through bonding under reduced pressure like a liquid crystal drop injection (one drop filling (ODF)) method for a liquid crystal panel. In the case of a gel electrolyte made with use of e.g. a polymer or an all-solid-state electrolyte, a polymer solution containing the electrolyte composition and a plasticizer is deposited on the photoelectric conversion layer by a casting method and then is removed by volatilization. Furthermore, the plasticizer is completely removed and thereafter sealing is performed similarly to the above-described method. It is preferable that this sealing be performed by using e.g. a vacuum sealer under an inert gas atmosphere or under reduced pressure. It is also possible that operation of heating and pressurizing is carried out according to need after the sealing in order to sufficiently impregnate the photoelectric conversion layer with the electrolyte.

In a preferred form of the photoelectric conversion element module of the present disclosure, one end of the second electrode of photoelectric conversion element-A is connected to the first electrode of photoelectric conversion element-B. Regarding this feature, it is possible to employ a configuration in which an extension part of the first electrode of photoelectric conversion element-B is in contact with one end of the second electrode of photoelectric conversion element-A. Alternatively, it is also possible to employ a configuration in which one end of the second electrode of photoelectric conversion element-A and the first electrode of photoelectric conversion element-B are connected to each other by a collector electrode or a connecting part formed of the above-described electrically-conductive material. Hereinafter, the connected portion of the collector electrode or the connecting part formed of an electrically-conductive material will be often referred to as the "interconnect part" for convenience. It is preferable that insulation treatment be performed for the interconnect part or a protective layer of e.g. resin or glass frit be formed on the interconnect part according to need.

If one end of the second electrode of photoelectric conversion element-A and the first electrode of photoelectric conversion element-B are connected to each other by the interconnect part, by providing an adhesion layer on both sides of the interconnect part, the base and the transparent substrate can be tightly bonded to each other and plural photoelectric conversion elements can be electrically connected in series to each other surely. In addition, because the adhesion layer can function as a protective layer, the contact of the interconnect part with the electrolyte can be prevented and the corrosion of the interconnect part due to the electrolyte can be prevented. The adhesion layer can be formed from e.g. an ultraviolet-curable adhesive or thermosetting adhesive. The interconnect part and the photoelectric conversion elements on both sides of this interconnect part are separated from each other by the adhesion layer. It is easy to form the adhesion layer provided on both sides of the interconnect part e.g. by applying an adhesive in such a manner as to cover the interconnect part by using e.g. a screen printing method or a dispenser and bonding the base and the transparent substrate to each other. However, the forming method for the adhesion layer is not particularly limited and the adhesion layer may be formed by another method. The bonding of the base and the transparent substrate under reduced pressure is preferable because voids attributed to air bubbles are hardly formed in the adhesion layer. After the bonding, the adhesion layer is cured by heat or ultraviolet while pressure is applied to the base and the transparent substrate. In the curing of the adhesion layer by ultraviolet, it is preferable to use a light blocking mask in order to prevent the photoelectric conversion layer from being irradiated with the ultraviolet.

If a collector electrode is provided, the collector electrode is equivalent to the current extraction area. It is preferable for the collector electrode to have low resistance and exhibit low contact resistance. Specific examples of the preferred material of the collector electrode include Ag, Au, Cu, Ni, Pt, Al, Cr, In, Sn, Zn, C, and alloys and solders of these elements. It is preferable to form the collector electrode by applying a conductor paste formed of any of these materials by using e.g. a screen printing method or a dispenser. According to need, all or part of the collector electrode may be formed from e.g. an electrically-conductive adhesive, electrically-conductive rubber, or anisotropic electrically-conductive adhesive. As described above, in a preferred form of the photoelectric conversion element module of the present disclosure, the collector electrode is provided at the outer edge part of the second electrode. For example, if the outer shape of the photoelectric conversion layer is a rectangle (composed of a side A, a side B, a side C, and a side D, and the side A and the side C are opposed to each other and the side B and the side D are opposed to each other), the collector electrode can be provided along the side A of the photoelectric conversion layer. In this case, the current extraction area of the first electrode is provided or disposed along the side C of the photoelectric conversion layer. Alternatively, the collector electrode can be provided in parallel to the side A, the side B, and the side D of the photoelectric conversion layer, i.e. into an angulated C-character shape. In this case, the current extraction area of the first electrode is provided or disposed along the side C of the photoelectric conversion layer. Alternatively, the collector electrode can be provided in parallel to the side A and the side B of the photoelectric conversion layer, i.e. into an L-character shape. In this case, the current extraction area of the first electrode is provided or disposed near corner parts of the side C and the side D of the photoelectric conversion layer. Furthermore, as described above, in a preferred form of the photoelectric conversion device, the collector electrode is provided on the second electrode. For example, the following structures can be exemplified as the structure of the collector electrode: a lattice structure, a comb-shape structure, and a structure obtained by combining a backbone electrode extending at the center and branch electrodes extending from this backbone electrode in the perpendicular direction. Depending on the case, the collector electrode may be extended to the inside of the photoelectric conversion layer in a comb-shape manner. The aperture ratio is sacrificed due to the provision of the collector electrode. However, by disposing the light collector, light is collected more strongly onto the vicinity of the current extraction area of the second electrode for example, and thus a problem that the existence of the collector electrode leads to power generation loss can be avoided differently from the related art.

The shape and size of the photoelectric conversion element can be arbitrarily decided according to need. For example if the shape is a rectangle, its width is e.g. 1 mm to 20 mm. The width and thickness (height) of the collector electrode can also be arbitrarily decided according to need. It is preferable that the width be e.g. 0.1 mm to 5 mm and the thickness be smaller than the total of the thicknesses of the photoelectric conversion layer and the first electrode and 100 $\mu$m. The number of photoelectric conversion elements included in the photoelectric conversion element module is essentially arbitrary.

The photoelectric conversion device and so forth can be fabricated based on various shapes, structures, and configurations depending on its use purpose and these factors are not particularly limited. Most typically, the photoelectric conversion device and so forth is used as a solar cell. In addition, it can be used also as e.g. a photosensitive sensor. Furthermore, electronic apparatus into which the photoelectric conversion device and so forth is incorporated may be any basically and encompasses both of portable electronic apparatus and stationary electronic apparatus. Examples of the electronic apparatus include cellular phones, mobile apparatus, robots, personal computers, in-vehicle apparatus, and various kinds of home electrical appliances. In these cases, the photoelectric conversion device and so forth is used as e.g. a power supply of these pieces of electronic apparatus.

[First Embodiment]

A first embodiment of the present disclosure relates to the photoelectric conversion device of the present disclosure and relates to the photoelectric conversion element module of the present disclosure. The photoelectric conversion device or the photoelectric conversion element module of the first embodiment or second to fourth embodiments of the present disclosure to be described later is used as a solar cell and incorporated in electronic apparatus as a power supply of the electronic apparatus. In the first embodiment, the photoelectric conversion element module has a so-called monolithic module structure and is a high-voltage, low-current solar cell capable of achieving a voltage of about 50 V.

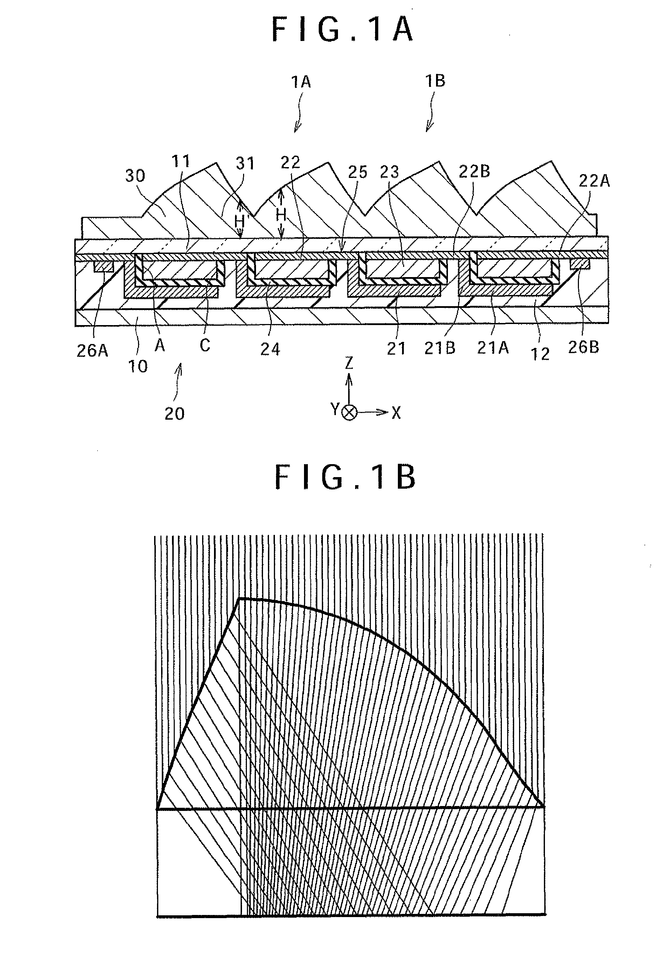

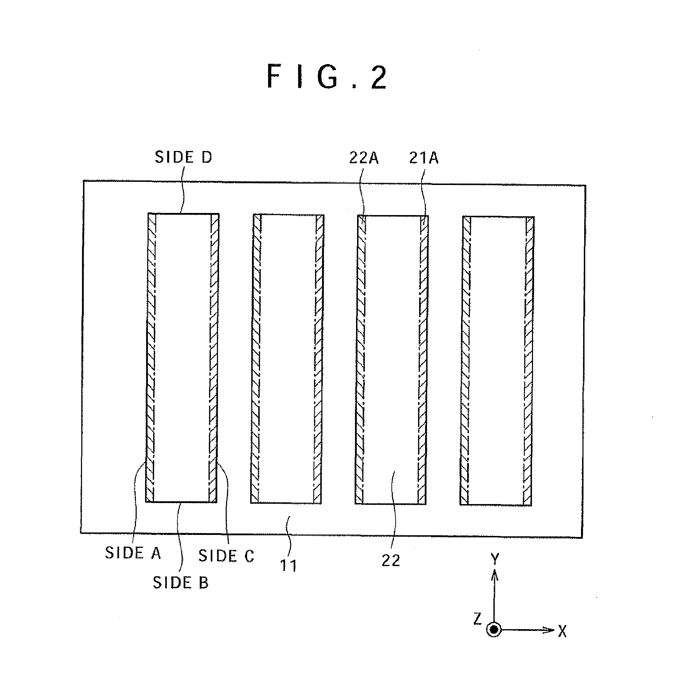

A photoelectric conversion device 1A of the first embodiment is shown in FIG. 1A, FIG. 1B, and FIG. 2. Specifically, FIG. 1A is a schematic sectional view. FIG. 1B is an enlarged schematic sectional view of a light collector. FIG. 2 is a schematic plan view of a second electrode. As shown in these drawings, the photoelectric conversion device 1A has a photoelectric conversion element 20 over a base 10 and a light collector 30 is disposed on the light incident side of the photoelectric conversion element 20. The photoelectric conversion element 20 is formed by stacking, from the base side,

(A) a first electrode 21,
(B) a photoelectric conversion layer 23, and
(C) a second electrode 22.

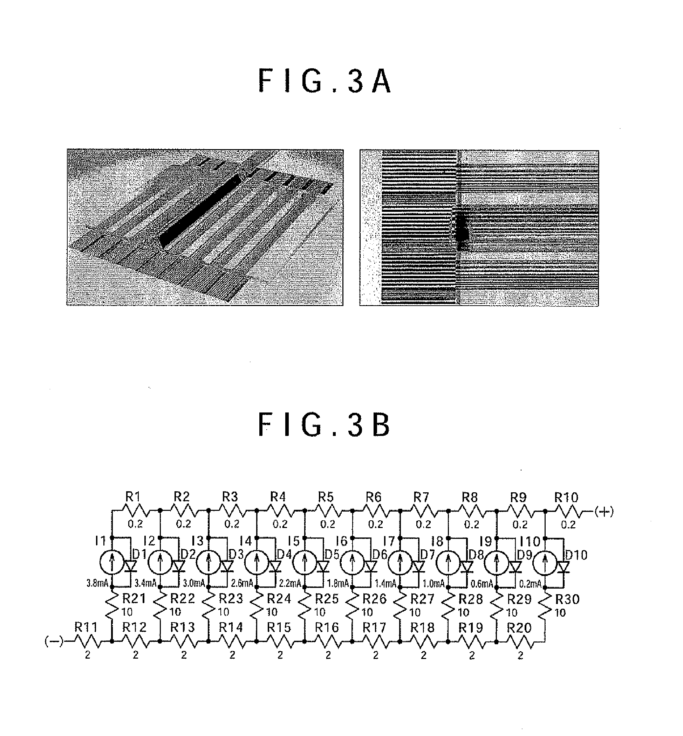

A photoelectric conversion element module 1B of the first embodiment has the plural photoelectric conversion elements 20 and the light collector 30 is disposed on the light incident side of the respective photoelectric conversion elements 20. The light collector 30 prepared as a monolithic component for the plural photoelectric conversion elements 20 is disposed. The left side of FIG. 3A shows a picture obtained by putting the light collector 30 of the first embodiment on a test chart and photographing it from the obliquely upper side, and the right side of FIG. 3A shows a picture obtained by photographing the same from directly above. The picture of the right side of FIG. 3A is obtained by photographing the test chart shown on the left side through the light collector 30 and an extension part 31 thereof.

The first electrode 21 is composed of carbon black and graphite grains. The photoelectric conversion layer 23 is composed of sintered-body microparticles of anatase titanium oxide $TiO_2$ carrying a sensitizing dye to be described later. The second electrode 22 is composed of fluorine-doped $SnO_2$ (FTO). The first electrode 21 is extended toward the upper side along the side surface of the photoelectric conversion layer 23. Between the photoelectric conversion layer (dye-sensitized semiconductor layer) 23 and the first electrode (counter electrode) 21, a porous insulating layer 24 composed of $TiO_2$ is provided. The porous insulating layer 24 is extended toward the upper side along the side surface of the photoelectric conversion layer 23. The photoelectric conversion layer 23, the first electrode 21, and the porous insulating layer 24 are impregnated with an electrolyte containing $I_2$ and NaI. The base 10 and a transparent substrate 11 covering the second electrode 22 are composed of glass.

The light intensity of light incident on the second electrode 22 is rendered uneven by the light collector 30 composed of an acrylic resin. Specifically, one end of the second electrode 22 of one photoelectric conversion element (photoelectric conversion element-A) is connected to the first electrode 21 of another photoelectric conversion element adjacent to this one end (photoelectric conversion element-B). Furthermore, the other end of the second electrode 22 of this one photoelectric conversion element (photoelectric conversion element-A) is insulated from the second electrode 22 of another photoelectric conversion element adjacent to the other end (photoelectric conversion element-C). In FIG. 1A, if the second photoelectric conversion element from the left is defined as photoelectric conversion element-A, the third photoelectric conversion element from the left corresponds to photoelectric conversion element-B and the leftmost photoelectric conversion element corresponds to photoelectric conversion element-C. As described above, an end of the first electrode 21 of photoelectric conversion element-B is extended toward the upper side along the side surface of the photoelectric conversion layer 23 thereof, and gets contact with the extension part of one end of the second electrode 22 of one photoelectric conversion element (photoelectric conversion element-A). Thereby, the first electrode 21 and the second electrode 22 are connected directly to each other. Specifically, an extension part 21B of the first electrode 21 of photoelectric conversion element-B is connected to an extension part 22B of one end of the second electrode 22 of photoelectric conversion element-A. Moreover, in this one photoelectric conversion element (photoelectric conversion element-A), the light incident on the second electrode 22 through the light collector 30 is collected by the light collector 30 more strongly onto part or an area (current extraction area side of the second electrode 22 or the vicinity of a current extraction area 22A of the second electrode 22) on the side on which an electrode having high electric resistance or an electrode having low electrical conductivity (in the first embodiment, the second electrode 22 having electric resistance $R_2$) is connected to an electrode having low electric resistance or an electrode having high electrical conductivity (in the first embodiment, the first electrode 21 having electric resistance $R_1$) included in the photoelectric conversion element (photoelectric conversion element-B) adjacent to one photoelectric conversion element (photoelectric conversion element-A). Specifically, in the first embodiment, the second electrode 22 corresponds to the electrode having high electric resistance and the first electrode 21 corresponds to the electrode having low electric resistance. Furthermore, light is collected more strongly onto the side of the current extraction area 22A of the second electrode 22 than onto the side of a current extraction area 21A of the first electrode 21.

An enlarged schematic partial sectional view of the light collector 30 in the first embodiment is shown in FIG. 1B. The trajectories of light beams passing through the light collector 30 are also shown in this diagram. The light collector 30 is bonded to the transparent substrate 11 by using an adhesive (not shown). In the light collector 30, "H" is defined as the height of the outer shape line of the light collector 30 on the basis of the light incident surface of the second electrode when the light collector 30 is cut by a virtual plane (XZ plane) that passes through the current extraction area 21A of the first electrode 21 and the current extraction area 22A of the second electrode 22 and is perpendicular to the light incident surface of the second electrode 22. Light is incident from the air on the light collector 30 composed of a material whose refractive index surpasses one (specifically, acrylic resin) and is output from the light collector 30 to be incident directly on the second electrode 22. Therefore, the height H increases in the direction from the current extraction area 21A of the first electrode 21 toward the current extraction area 22A of the second electrode 22. That is, the function of this outer shape line of the light collector 30 is a function that increases monotonically and smoothly in the direction from the current extraction area 21A of the first electrode 21 toward the current extraction area 22A of the second electrode 22. Moreover, a gap 25 exists between one photoelectric conversion element (photoelectric conversion element-A) and another photoelectric conversion element (photoelectric conversion element-B) adjacent to this one photoelectric conversion element (photoelectric conversion element-A). Above the gap 25, the extension part 31 of the light collector is disposed as a component monolithic with the light collector 30. Light passing through the extension part 31 of the light collector reaches one end (or the vicinity thereof) of the second electrode 22 of one photoelectric conversion element (photoelectric conversion element-A). Furthermore, H' is defined as the height of the outer shape line of the extension part 31 of the light collector on the basis of the light incident surface of the second electrode when the extension part 31 of the light collector is cut by a virtual plane that passes through the current extraction area 21A of the first electrode 21 and the current extraction area 22A of the second electrode 22 and is perpendicular to the light incident surface of the second electrode 22. The height H' decreases in such a direction as to get away from the current extraction area 22A of the second electrode 22. That is, the function of this outer shape line of the extension part 31 of the light collector is a function that decreases monotonically and smoothly in such a direction as to get away from the current extraction area 22A of the second electrode 22. The outer shape line of the light collector 30 is an upwardly-convex curve. Moreover, the light collector 30 and its extension part 31 have the axis line extending along the Y-direction and have a shape similar to a cylindrical lens, and the light collector 30 is an aspherical lens having positive power. That is, the axis line of the light collector 30 and its extension part 31 does not have optical power in the Y-direction but have optical power in the XZ plane, and the light collector 30 and its extension part 31 are formed of an asymmetrical cylindrical lens.

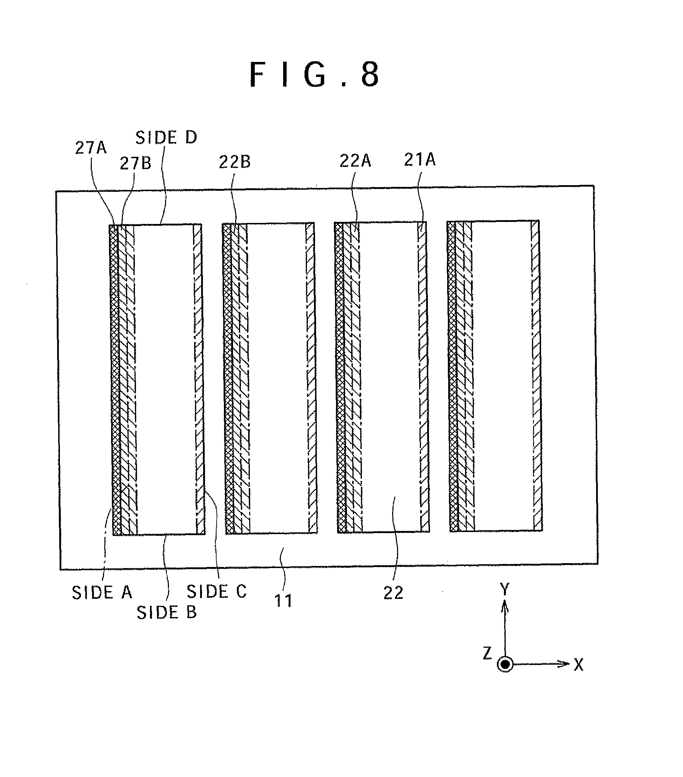

In the first embodiment, the current extraction area 21A of the first electrode 21 and the current extraction area 22A of the second electrode 22 have a rectangular planar shape (see the schematic plan view of FIG. 2). The current extraction area 21A of the first electrode 21 is encompassed in the first electrode 21 and can not be definitely discriminated. Similarly, the current extraction area 22A of the second electrode 22 is encompassed in the second electrode 22 and can not be definitely discriminated. The outer shape of the photoelectric conversion layer 23 is a rectangle composed of a side A, a side B, a side C, and a side D. The side A and the side C are opposed to each other and the side B and the side D are opposed to each other. The current extraction area 22A of the second electrode 22 is located along the side A of the photoelectric conversion layer 23, and the current extraction area 21A of the first electrode 21 is located along the side C of the photoelectric conversion layer 23. In FIG. 2, in order to clearly show the current extraction areas 21A and 22A, they are surrounded by a one-dot chain line and a full line and are given hatched lines. This applies also to FIG. 8, FIG. 12, and FIG. 13 to be described later. In FIG. 2, FIG. 8, FIG. 12, and FIG. 13, for simplification of the drawings, only the part of the second electrode 22 and so forth included in the photoelectric conversion element is shown and hatched lines are given to various kinds of areas in order to clearly show these areas.

Incident light transmitted through the light collector 30 and the transparent substrate 11 excites the sensitizing dye in the photoelectric conversion layer (dye-sensitized semiconductor layer) 23 to generate electrons. This electron rapidly moves from the sensitizing dye to a semiconductor microparticle. On the other hand, the sensitizing dye that has lost the electron receives an electron from an ion of the electrolyte with which the semiconductor microparticles and the whole of the porous insulating layer 24 are impregnated, and the molecule that has passed the electron receives an electron again at the surface of the first electrode (counter electrode) 21. Due to this series of reaction, an electromotive force is generated between the second electrode 22 and the first electrode (counter electrode) 21 electrically connected to the photoelectric conversion layer (dye-sensitized semiconductor layer) 23. The photoelectric conversion is achieved in this manner. In this case, the total electromotive force of the electromotive forces of the plural photoelectric conversion elements connected in series between an extraction electrode (positive electrode) 26A and an extraction electrode (negative electrode) 26B for these photoelectric conversion elements is generated.

A photoelectric conversion element over which the light collector 30 was not disposed was prepared as a comparative example 1A.

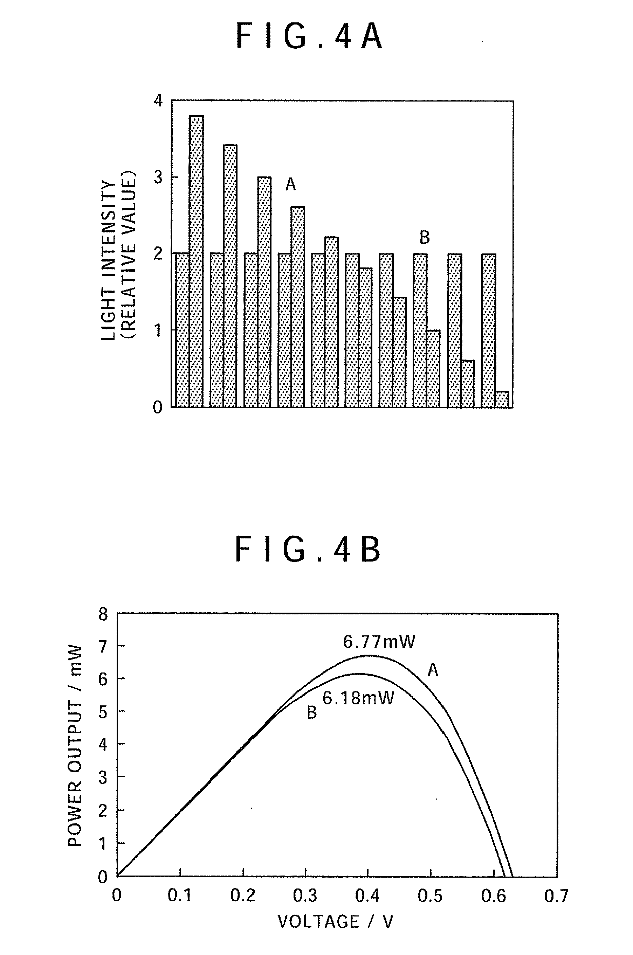

The equivalent circuit of one photoelectric conversion element in the first embodiment is shown in FIG. 3B. One photoelectric conversion element was divided into 10 segments, and a simulation on the I-V characteristic was performed based on this equivalent circuit by using a circuit simulator, LT Spice IV. In addition, a simulation on the I-V characteristic of the photoelectric conversion element of the comparative example 1A was performed. The results of these simulations are shown in FIGS. 4A and 4B.

FIG. 4A shows the light intensity distribution in one photoelectric conversion element: "A" shows the first embodiment and "B" shows the comparative example 1A. The ordinate indicates the relative value of the light intensity. The left end of the abscissa indicates one end of the second electrode 22 and the right end indicates the other end of the second electrode 22. In the first embodiment, the light intensity is inclined. Specifically, the current value of the virtual current source closest to one end of the second electrode 22 is 3.8 milliamperes, and the current value of the current source sequentially decreases to 3.4 milliamperes, 3.0 milliamperes, and so forth as the distance from one end of the second electrode 22 becomes longer. The resistance of the second electrode 22 between segments was set to 2 ohms. The resistance of the first electrode 21 between segments was set to 0.2 ohms. The internal resistance of one segment was set to 10 ohms. On the other hand, in the comparative example 1A, the light intensity is uniform. Specifically, all of the current values of 10 virtual current sources included in the equivalent circuit are 2.0 milliamperes. The results of the power output of the first embodiment and the comparative example 1A are shown in "A" and "B" in FIG. 4B. The maximum power output was 6.77 milliwatts in the first embodiment and was 6.18 milliwatts in the comparative example 1A. That is, it is shown that the maximum power output is increased by the characteristic that, in photoelectric conversion elemerat-A, light incident on the second electrode 22 through the light collector 30 is collected by the light collector 30 more strongly onto part or an area of the second electrode 22 adjacent to photoelectric conversion element-B.

As just described, in the photoelectric conversion device or the photoelectric conversion element module of the first embodiment, the light intensity of light incident on the second electrode 22 is rendered uneven by the light collector 30. Thus, the electrical generating capacity differs depending on the area of the second electrode 22. As a result, for example, the distance across which an electron generated in the photoelectric conversion layer 23 and headed toward the current extraction area 22A of the second electrode 22 passes through the second electrode 22 can be shortened as much as possible, which can reduce power generation loss.

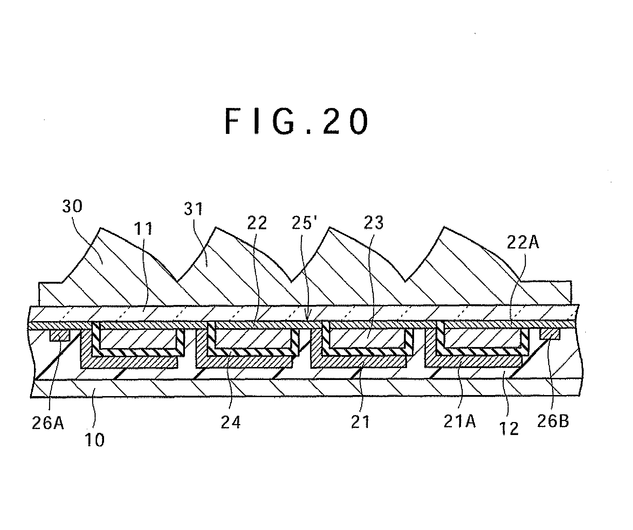

As shown in a schematic sectional view of FIG. 20, a photoelectric conversion element module in which the attaching direction of the light collector 30 was set opposite to that of the first embodiment was fabricated as a comparative example 1B. Specifically, in the comparative example 1B, the height H increases in the direction from the current extraction area 22A of the second electrode 22 toward the current extraction area 21A of the first electrode 21. That is, in the comparative example 1B, the function of the outer shape line of the light collector 30 is a function that increases monotonically and smoothly in the direction from the current extraction area 22A of the second electrode 22 toward the current extraction area 21A of the first electrode 21. Furthermore, a gap 25' exists between one photoelectric conversion element (photoelectric conversion element-A) and another photoelectric conversion element (photoelectric conversion element-C) adjacent to this one photoelectric conversion element (photoelectric conversion element-A). Above the gap 25', the extension part 31 of the light collector is disposed. Light passing through the light collector 30 and the extension part 31 of the light collector is collected onto the one end side of the first electrode 21 of one photoelectric conversion element (photoelectric conversion element-A).

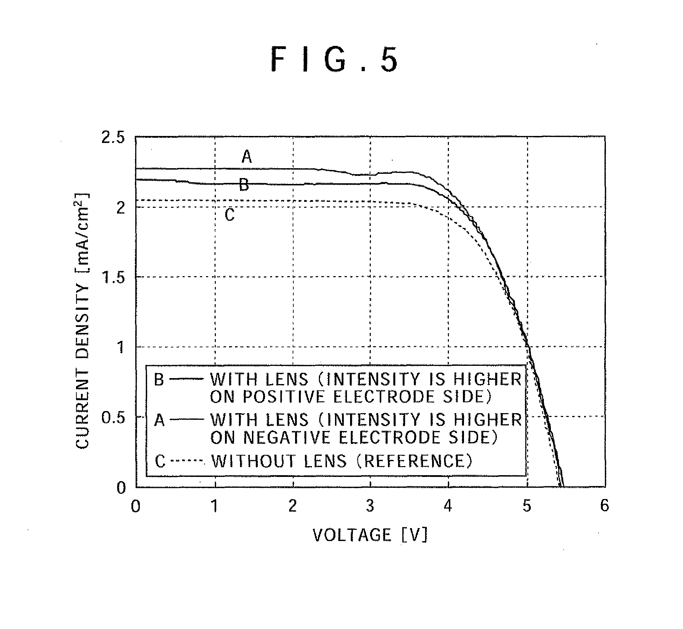

The results of power generation tests are shown in FIG. 5. As shown in FIG. 5, the energy conversion efficiency of the photoelectric conversion element module of the first embodiment (shown by "A" in FIG. 5) was 8.47%. On the other hand, the energy conversion efficiency of the comparative example 1B (shown by "B" in FIG. 5) was 8.25%. Furthermore, the energy conversion efficiency of the photoelectric conversion element module in which the light collector 30 was not disposed (comparative example 1C, shown by "C" in FIG. 5) was 7.72%. As just described, it is confirmed that the energy conversion efficiency is enhanced by collecting light more strongly onto the vicinity of the current extraction area 22A of the second electrode 22. The values of the open voltage $V_{oc}$ (unit: volt), the current density $J_{sc}$ (unit: mA/cm$^2$), and the fill factor FF (unit: %) of the first embodiment, the comparative example 1B, and the comparative example 1C are shown in Table 1 made below.

In the comparative example 1B, a larger number of electrons gather in the area of the second electrode 22 located above the current extraction area 21A of the first electrode 21. These electrons move toward the current extraction area 22A of the second electrode 22. This movement distance is long. Therefore, much power generation loss is caused. In contrast, in the first embodiment, a larger number of electrons gather in the vicinity of the current extraction area 22A of the second electrode 22. These electrons move toward the current extraction area 22A of the second electrode 22 but this movement distance is short. Thus, the power generation loss can be reduced.

[Table 1]

|  | $V_{oc}$ | $J_{sc}$ | FF |
|---|---|---|---|
| First Embodiment | 5.425 | 2.28 | 68.5 |
| Comparative Example 1B | 5.475 | 2.20 | 68.6 |
| Comparative Example 1C | 5.467 | 2.05 | 68.8 |

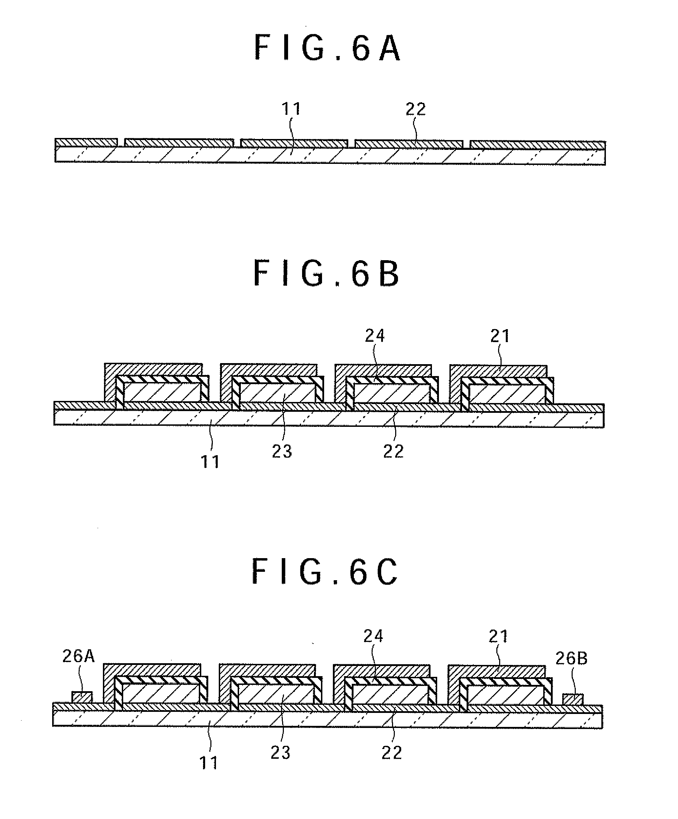

The photoelectric conversion device 1A or the photoelectric conversion element module 1B of the first embodiment can be manufactured by e.g. the following method to be described with reference to FIGS. 6A to 6C, which are schematic partial sectional views of the transparent substrate and so forth.

[Step-100]

Specifically, first, an FTO glass substrate for a solar cell (having sheet resistance of 10 Ω/□), obtained by forming an FTO layer on the transparent substrate 11 formed of a glass substrate, is prepared. This FTO layer is subjected to patterning by etching to obtain the second electrode 22 patterned in each photoelectric conversion element 20 (see FIG. 6A). Thereafter, ultrasonic cleaning is performed by using acetone, alcohol, an alkaline cleaning liquid, and ultrapure water in turn, and drying is sufficiently performed.

[step-110]

Subsequently, a titanium oxide paste having a thickness of 20 $\mu$m is applied on the second electrode 22 based on a screen printing method, and thereby a porous $TiO_2$ layer is obtained. This porous $TiO_2$ layer is baked at 500°C for 30 minutes in an electric furnace. After cooling, the porous $TiO_2$ layer is immersed in a 0.1 mol/L aqueous solution of $TiCl_4$ and held therein at "70°C for 30 minutes. Thereafter, it is sufficiently cleaned by pure water and ethanol. After drying, it is baked again at 500°C for 30 minutes in an electric furnace. In this manner, the photoelectric conversion layer 23 (that has not yet carried the sensitizing dye) composed of an anatase $TiO_2$ sintered body is obtained.

[Step-120]

Thereafter, a $TiO_2$ paste for screen printing, prepared by using commercially available $TiO_2$ particles (having a particle diameter of 200 nm), terpineol, and ethyl cellulose, is applied on the $TiO_2$ sintered body (photoelectric conversion layer 23). The $TiO_2$ paste is dried to obtain a $TiO_2$ layer. Thereafter, as the first electrode (counter electrode), a paste for screen printing, prepared by using commercially available carbon black, commercially available graphite grains, terpineol, and ethyl cellulose, is applied on the $TiO_2$ layer. After this paste is dried, baking is performed at 450° C for 30 minutes in an electric furnace. In this manner, the porous insulating layer 24 and the porous first electrode (counter electrode) 21 can be obtained (see FIG. 6B). The first electrode 21 is in contact with the second electrode 22.

[Step-130]

Subsequently, the $TiO_2$ sintered body is made to carry the sensitizing dye by immersion at a room temperature for 48 hours in a tert-butyl alcohol/acetonitrile mixed solvent (volume ratio is 1 : 1) containing 0.5 millimole cis-bis (isothiocyanate)-N,N-bis(2,2'-dipyridyl-4,4'-dicarboxylic acid)-ruthenium(II) ditetrabutylammonium salt (N719 dye). Furthermore, the $TiO_2$ sintered body made to carry the sensitizing dye is cleaned by acetonitrile and dried at a dark place. In this manner, the photoelectric conversion layer (dye-sensitized semiconductor layer) 23 can be obtained.

[Step-140]

An electrolyte composition is prepared by dissolving 0.045-gram sodium iodide (NaI), 1.11-gram 1-propyl-2,3-dimethylimidazolium iodide, 0.11-gram iodine ($I_2$), and 0.081-gram 4-tert-butylpyridine in 3-gram Y-butyrolactone. The thus prepared electrolyte composition is applied on the entire surface of the first electrode side by using a dispenser to thereby impregnate the inside of the first electrode 21, the porous insulating layer 24, and the photoelectric conversion layer (dye-sensitized semiconductor layer) 23 with the electrolyte composition. The excess electrolyte composition leaked out from these layers is cleanly wiped out.

[Step-150]

Next, a titanium foil is bonded to extraction electrode bonding parts formed of the FTO film located at both ends of the transparent substrate 11 by an ultrasonic soldering method, and thereby the extraction electrodes 26A and 26B are provided (see FIG. 6C). Thereafter, the base 10 formed of glass is bonded to the first electrode and so forth with the intermediary of a bonding layer 12 formed of an adhesive, so that the photoelectric conversion element module 1B is obtained. In this manner, the photoelectric conversion element 20 shown in the schematic sectional view of FIG. 1A can be obtained.

[Step-160]

Thereafter, the light collector 30 is bonded onto the transparent substrate 11 by using an adhesive (not shown), so that the photoelectric conversion device 1A or the photoelectric conversion element module 1B of the first embodiment can be obtained.

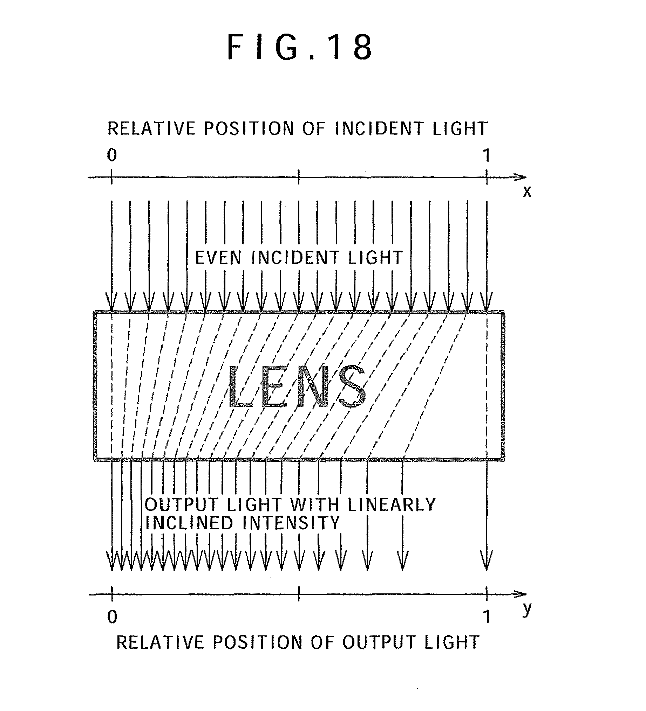

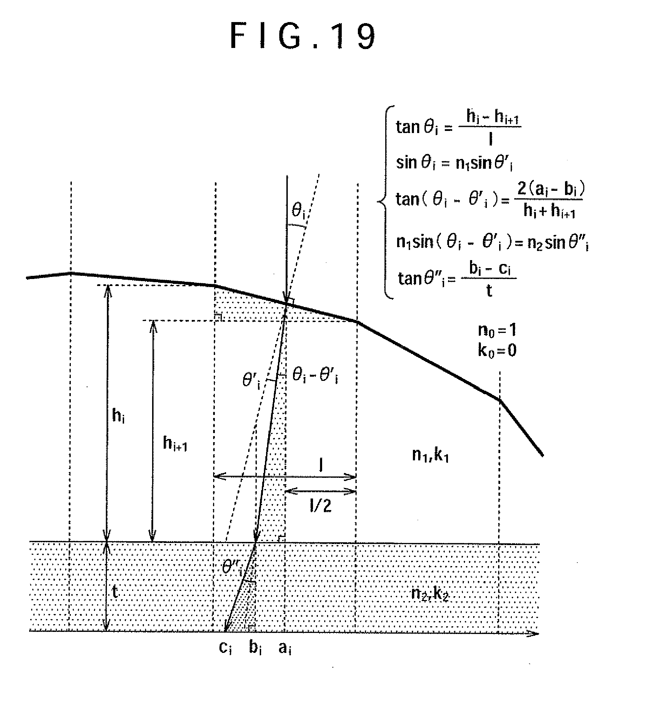

With reference to FIG. 18 and FIG. 19, one example of how to obtain the outer shape line of the light collector 30 will be described below.

Here, suppose that, as shown in a conceptual diagram of FIG. 18, light having uniform light intensity is incident on a lens equivalent to the light collector 30 and is output from the lens with linearly inclined light intensity. The coordinate of the incident light is represented by x from x = 0.0 to x = 1.0. Furthermore, the coordinate of the output light corresponding to this incident light is represented by y from y = 0.0 to Y = 1.0. The relationship between x and y is represented by equation (A) shown below.

$$y = 1 - (1 - x)^{1/2} \quad \cdots \quad (A)$$

Specifically, light having a certain x-coordinate value enters the lens and is output from the lens to reach the second electrode. At this time, the value of the coordinate of this light at the second electrode (y-coordinate) can be obtained by equation (A).

Furthermore, the outer shape line (lens surface shape) of the light collector 30 can be obtained by e.g. the following method. Specifically, for example, the height of the left end of the lens is defined as $h_o$ (initial value). Subsequently, a y-coordinate value is obtained from the desired x-coordinate value based on equation (A). On the other hand, height $h_i$ is so decided that the y-coordinate value obtained from the respective equations shown in FIG. 19 corresponds with the y-coordinate value obtained based on equation (A). That is, operation of obtaining $h_{i+1}$ satisfying the function $f(a_i) = C_i$ in FIG. 19 is carried out. This operation is sequentially carried out to decide $h_2$, $h_3$, $h_4$ ... and these heights are coupled to each other by a smooth curve.

[Second Embodiment]

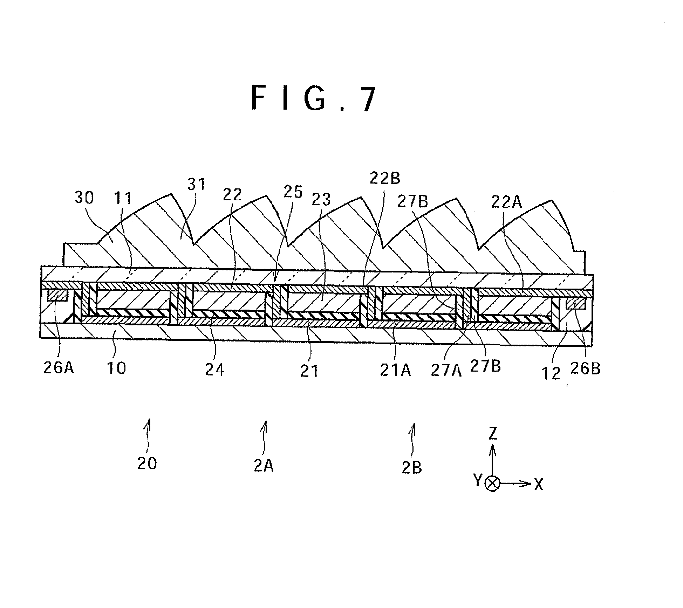

The second embodiment is a modification of the first embodiment. A photoelectric conversion element module of the second embodiment has a so-called Z-module structure. It is suitable for a small module and suitable to obtain a middle voltage (e.g. 2 to 10 volts). FIG. 7 is a schematic sectional view of a photoelectric conversion device 2A and a photoelectric conversion element module 2B of the second embodiment, and FIG. 8 is a schematic plan view of the second electrode.

In the second embodiment, one end of the second electrode 22 of photoelectric conversion element-A is connected to the first electrode 21 of photoelectric conversion element-B. Specifically, one end of the second electrode 22 of photoelectric conversion element-A is connected to the first electrode 21 of photoelectric conversion element-B by a connecting part (interconnect part 27A) formed of an electrically-conductive material. Furthermore, an adhesion layer 27B is provided on both sides of the interconnect part 27A. This can tightly bond the base 10 and the transparent substrate 11 to each other and allows plural photoelectric conversion elements to be electrically connected in series to each other surely. In addition, the adhesion layer 27B can function as a protective layer. Thus, it can prevent the interconnect part 27A from getting contact with the electrolyte and prevent the corrosion of the interconnect part 27A due to the electrolyte. The adhesion layer 27B is formed of an ultraviolet-curable adhesive. The interconnect part 27A and the photoelectric conversion elements on both sides of this interconnect part 27A are separated from each other by the adhesion layer 27B.

Except for the above-described point, the photoelectric conversion device 2A or the photoelectric conversion element module 2B of the second embodiment can have configuration and structure similar to those of the photoelectric conversion device 1A or the photoelectric conversion element module 1B of the first embodiment. Thus, detailed description thereof is omitted.

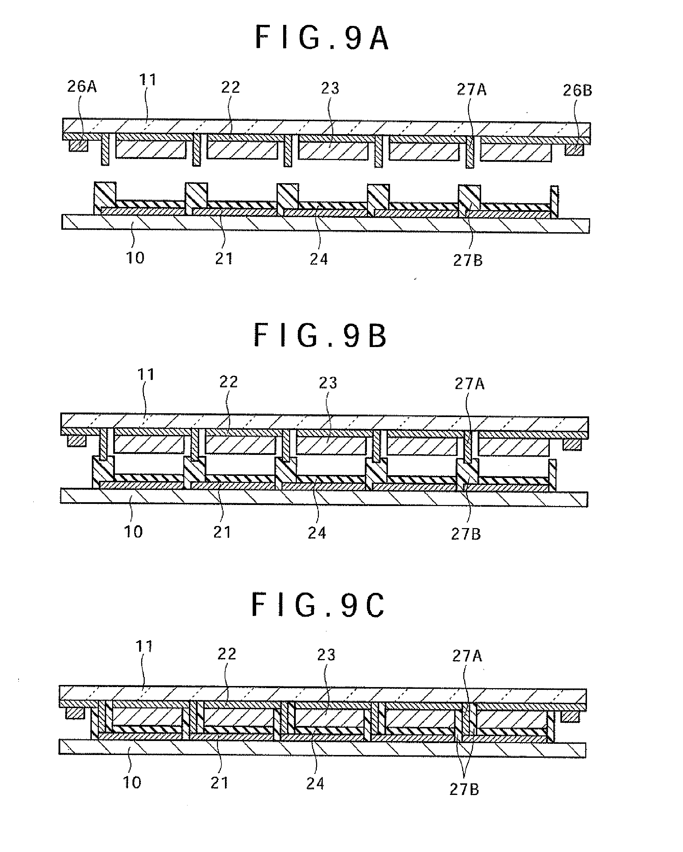

The outline of a manufacturing method for the photoelectric conversion device or the photoelectric conversion element module of the second embodiment will be described below with reference to FIGS. 9A to 9C, which are schematic partial sectional views of the transparent substrate and so forth.

[Step-200]

First, similarly to [Step-100] of the first embodiment, an FTO glass substrate for a solar cell (having sheet resistance of 10 $\Omega/\square$ obtained by forming an FTO layer on the transparent substrate 11 formed of a glass substrate, is prepared. This FTO layer is subjected to patterning by etching to obtain the second electrode 22 patterned in each photoelectric conversion element 20.

[Step-210]

Subsequently, similarly to [Step-110] of the first embodiment, the photoelectric conversion layer 23 (that has not yet carried the sensitizing dye) composed of an anatase $TiO_2$ sintered body is obtained.

[Step-220]

Thereafter, on the area of the transparent substrate 11 between the photoelectric conversion layers 23, the connecting part (interconnect part 27A) formed of an electrically-conductive material is formed based on e.g. a screen printing method. In this manner, the state shown in FIG. 9A can be obtained. Furthermore, the extraction electrodes 26A and 26B are provided similarly to [Step-150] of the first embodiment.

[Step-230]

Thereafter, similarly to [Step-130] of the first embodiment, the $TiO_2$ sintered body is made to carry the sensitizing dye, and thereby the photoelectric conversion layer (dye-sensitized semiconductor layer) 23 is obtained.

[Step-240]

On the base 10, as the first electrode (counter electrode), a paste for screen printing, prepared by using commercially available carbon black, commercially available graphite grains, terpineol, and ethyl cellulose, is applied. After this paste is dried, a $TiO_2$ paste for screen printing, prepared by using commercially available $TiO_2$ particles (having a particle diameter of 200 nm), terpineol, and ethyl cellulose, is applied on the previously-formed layer. After the $TiO_2$ paste is dried to obtain a $TiO_2$ layer, baking is performed at 450°C for 30 minutes in an electric furnace. In this manner, the porous insulating layer 24 and the porous first electrode (counter electrode) 21 can be obtained.

[Step-250]

Subsequently, on the area of the base 10 and the first electrode 21 between the porous insulating layers 24, the adhesion layer 27B is formed based on e.g. a screen printing method. In this manner, the state shown in FIG. 9A can be obtained.

[Step-260]

Thereafter, the base 10 and the transparent substrate 11 are set opposed to each other and brought close to each other. Thereby, as shown in FIG. 9B, the connecting part 27A enters the adhesion layer 27B (see FIG. 9B), and finally the state shown in FIG. 9C can be obtained.

[Step-270]

Furthermore, the inside of the first electrode 21, the porous insulating layer 24, and the photoelectric conversion layer (dye-sensitized semiconductor layer) 23 is impregnated with the same electrolyte composition as that in [Step-140] of the first embodiment. Thereafter, the outer circumferential part of the base 10 and the transparent substrate 11 is sealed by the bonding layer 12, and thereby the photoelectric conversion element 20 can be obtained. Subsequently, the light collector 30 is bonded onto the transparent substrate 11 by using an adhesive (not shown), so that the photoelectric conversion device 2A or the photoelectric conversion element module 2B of the second embodiment can be obtained.

[Third Embodiment]

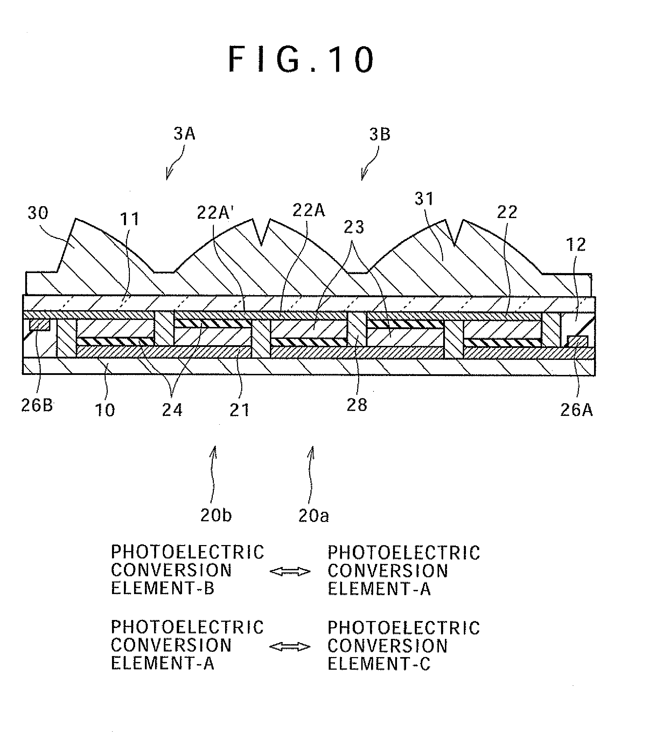

The third embodiment is also a modification of the first embodiment. A photoelectric conversion element module of the third embodiment has a so-called W-module structure, which allows increase in the module size comparatively easily. FIG. 10 is a schematic sectional view of a photoelectric conversion device 3A and a photoelectric conversion element module 3B of the third embodiment.

In the third embodiment, a photoelectric conversion element 20a and a photoelectric conversion element 20b are connected in series. The stacking structure of the first electrode, the photoelectric conversion layer, and the second electrode of the photoelectric conversion element 20b is vertically reversed from that of the photoelectric conversion element 20a. The photoelectric conversion elements are separated from each other by a sealing layer (spacer) 28 formed of a sealant.

If the photoelectric conversion element 20a corresponds to photoelectric conversion element-A and the photoelectric conversion element 20b corresponds to photoelectric conversion element-B, because of $R_2 < R_1$, in the photoelectric conversion element 20a (equivalent to photoelectric conversion element-A), light is collected more strongly onto the area (vicinity of the current extraction area 22A of a first electrode 22) of the photoelectric conversion element 20a (equivalent to photoelectric conversion element-A) adjacent to the photoelectric conversion element 20b (equivalent to photoelectric conversion element-B). On the other hand, if the photoelectric conversion element 20b corresponds to photoelectric conversion element-A and the photoelectric conversion element 20a corresponds to photoelectric conversion element-C, because of $R_2 < R_1$, in the photoelectric conversion element 20b (equivalent to photoelectric conversion element-A), light is collected more strongly onto the area (vicinity of a current extraction area 22A' of the second electrode 22) of the photoelectric conversion element 20b (equivalent to photoelectric conversion element-A) adjacent to the photoelectric conversion element 20a (equivalent to photoelectric conversion element-C). That is, the arrangement of the light collector 30 and the extension part 31 thereof in the photoelectric conversion element 20a and the arrangement of the light collector 30 and the extension part 31 thereof in the photoelectric conversion element 20b are in a mirror-image relationship. The shapes of the respective light collectors 30 and the extension parts 31 thereof may be substantially the same as those described for the first embodiment for example.

Except for the above-described point and appropriate changes of constituent materials, the photoelectric conversion device 3A or the photoelectric conversion element module 3B of the third embodiment can have configuration and structure similar to those of the photoelectric conversion device 1A or the photoelectric conversion element module 1B of the first embodiment. Thus, detailed description thereof is omitted.

[Fourth Embodiment]

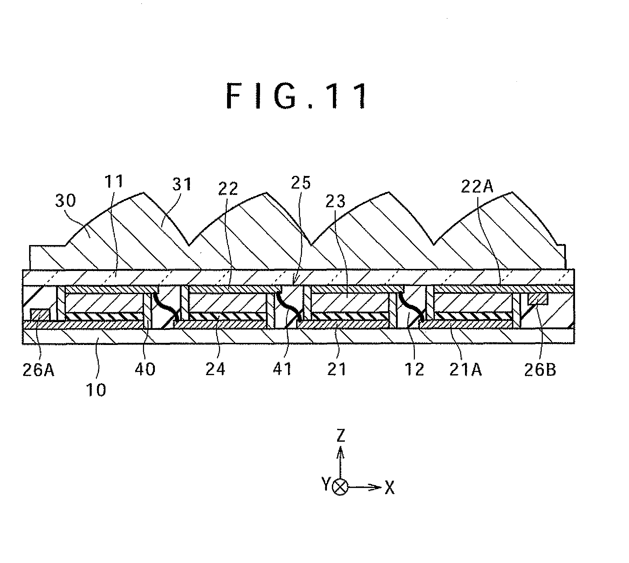

The fourth embodiment is also a modification of the first embodiment. A photoelectric conversion device of the fourth embodiment is formed of the photoelectric conversion device (single-cell structure) configured by one photoelectric conversion element over which the light collector described for the first embodiment is disposed. Alternatively, as shown in a schematic sectional view of FIG. 11, it has a so-called opposed cell module structure configured by the plural photoelectric conversion elements described for the first embodiment. However, differently from the first embodiment, the first electrode 21 of each photoelectric conversion element and the second electrode 22 of the photoelectric conversion element adjacent to this photoelectric conversion element are connected in series to each other by an interconnect 41. Furthermore, a sealing layer (spacer) 40 formed of a sealant is provided on the side surface of the porous insulating layer 24 and the photoelectric conversion layer (dye-sensitized semiconductor layer) 23. Except for the above-described point, the photoelectric conversion element, the photoelectric conversion device, or the photoelectric conversion element module of the fourth embodiment can have configuration and structure similar to those of the photoelectric conversion element 20, the photoelectric conversion device 1A, or the photoelectric conversion element module 1B of the first embodiment. Thus, detailed description thereof is omitted.

Although preferred embodiments of the present disclosure have been described above, the present disclosure is not limited to these embodiments. The configurations, structures, manufacturing conditions, materials used in the manufacturing, and so forth of the photoelectric conversion element, the photoelectric conversion device, or the photoelectric conversion element module described for the embodiments are examples and can be arbitrarily changed. Furthermore, the number of photoelectric conversion elements included in the photoelectric conversion element module is also an example and can be arbitrarily changed.

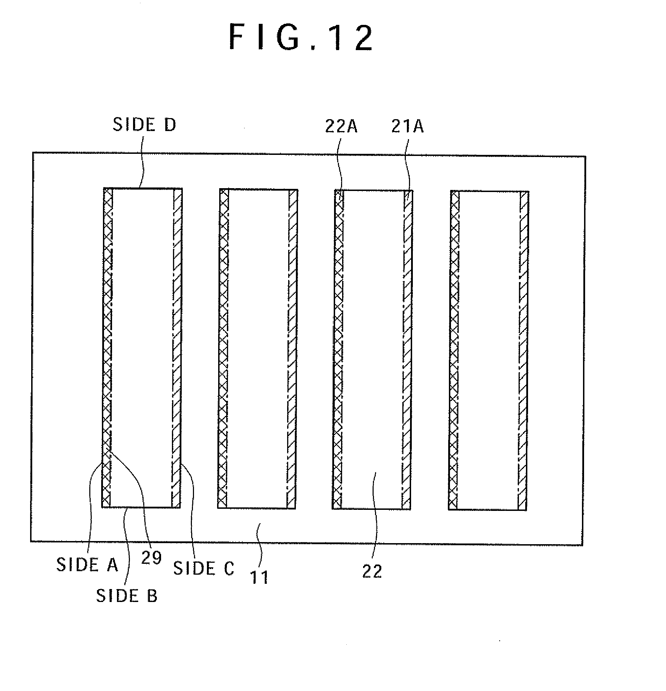

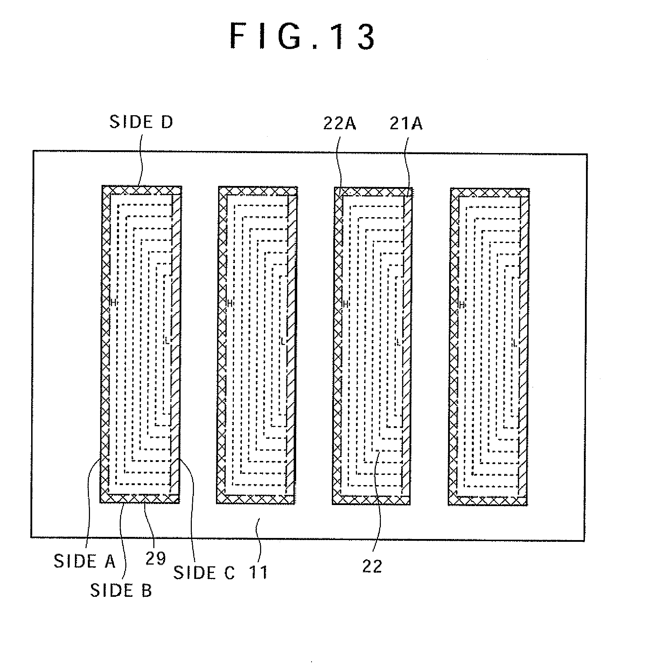

The photoelectric conversion element, the photoelectric conversion device, or the photoelectric conversion element module in the above-described embodiments can have a configuration in which a collector electrode (bus bar) 29 is provided on the second electrode. FIG. 12 and FIG. 13 are schematic plan views of the second electrode. As shown in FIG. 12 or FIG. 13, the respective embodiments can have a configuration in which the collector electrode 29 is provided at the outer edge part of the second electrode 22. The collector electrode 29 can be formed based on a screen printing method by using a silver paste for example. The collector electrode 29 is equivalent to the current extraction area of the second electrode 22. The collector electrode 29 is provided along the side A of the photoelectric conversion layer 23. In this case, the current extraction area 21A of the first electrode 21 is located along the side C of the photoelectric conversion layer 23 (see FIG. 12). Alternatively, the collector electrode 29 is provided in parallel to the side A, the side B, and the side D of the photoelectric conversion layer 23, i.e. into an angulated C-character shape. In this case, the current extraction area 21A of the first electrode 21 is located along the side C of the photoelectric conversion layer 23 (see FIG. 13). Alternatively, the collector electrode 29 is provided in parallel to the side A and the side B of the photoelectric conversion layer 23, i.e. into an L-character shape. In this case, the current extraction area 21A of the first electrode 21 is located near corner parts of the side C and the side D of the photoelectric conversion layer 23. Although the current extraction area 21A of the first electrode 21 is indicated by a one-dot chain line in FIG. 12 and FIG. 13, it is encompassed in the first electrode 21 and can not be definitely discriminated. In FIG. 13 to FIG. 16, the contour of the height of the light collector is indicated by a dotted line in order to show change in the height of the light collector. The area given "H" indicates the area in which the height of the light collector is the highest and the area given "L" indicates the area in which the height of the light collector is the lowest. The height of the light collector gradually increases in the direction from the area given "L" toward the area given "H."

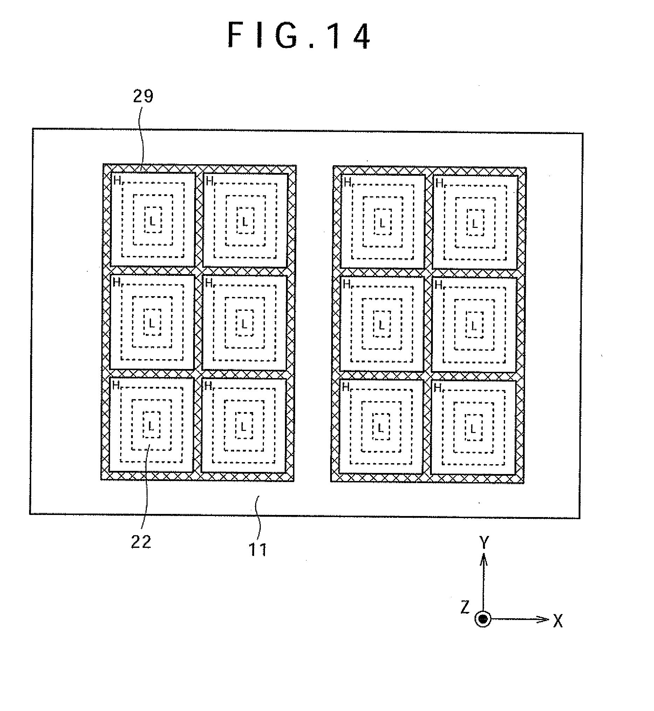

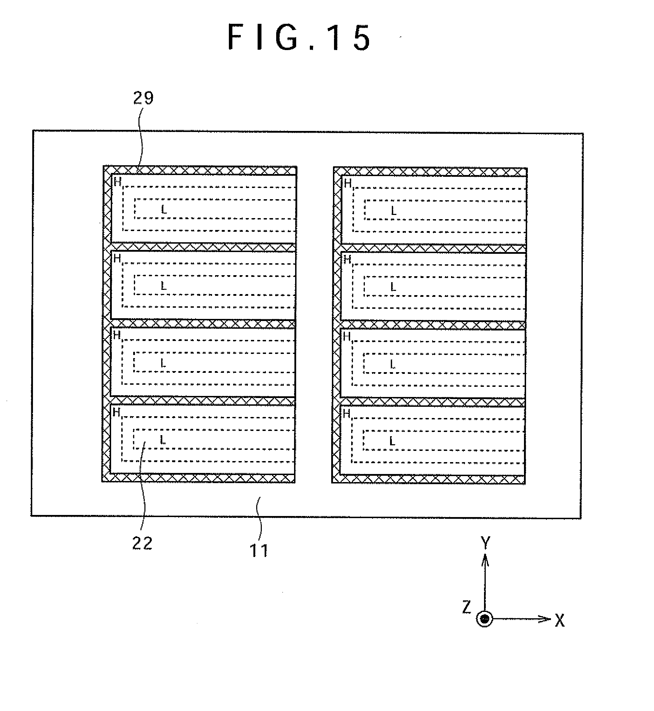

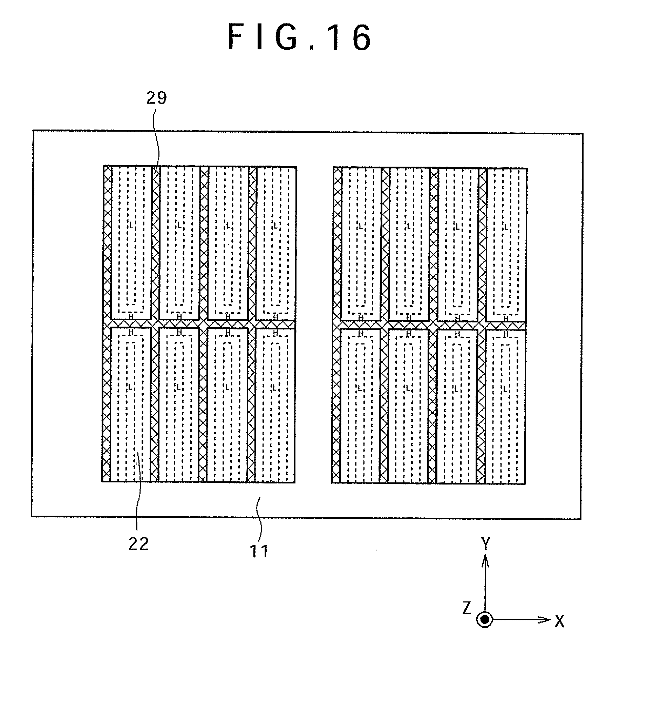

Furthermore, e.g. the following structures can be exemplified as the structure of the collector electrode 29: a lattice structure (see FIG. 14); a comb-shape structure (see FIG. 15); and a structure obtained by combining a backbone electrode extending at the center and branch electrodes extending from this backbone electrode in the perpendicular direction (see FIG. 16). Depending on the case, the collector electrode may be extended to the inside of the photoelectric conversion layer in a comb-shape manner.

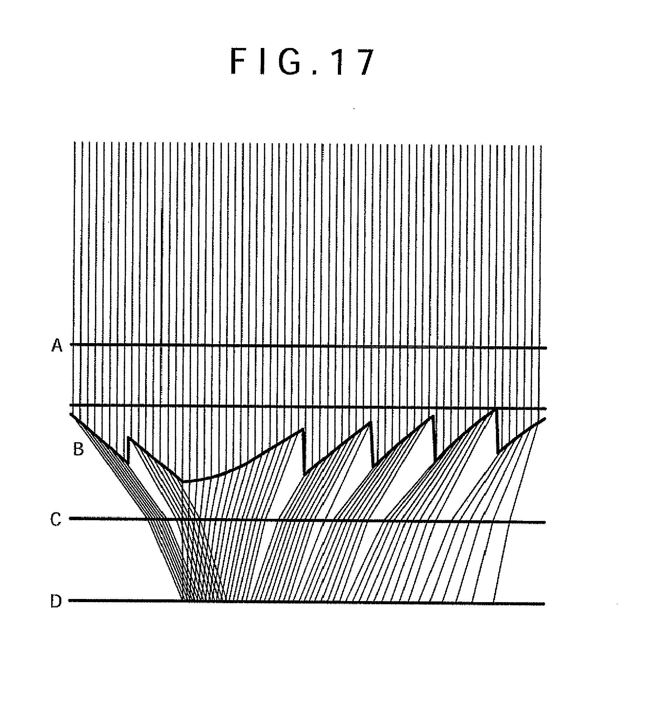

As shown in a conceptual diagram of FIG. 17, the light collector may be formed of a Fresnel lens. This can decrease the thickness of the light collector. In FIG. 17, the trajectories of light beams passing through the light collector are also shown. In FIG. 17, "A" indicates the light incident surface of the light collector. "B" indicates the light output surface (Fresnel lens surface) of the light collector. "C" indicates the light incident surface of the transparent substrate. "D" indicates the light incident surface of the second electrode. A space exists between the light output surface (Fresnel lens surface) of the light collector and the light incident surface of the transparent substrate. In such a configuration, the light collector is located above the transparent substrate by using an appropriate section. If a Fresnel lens surface is employed as the light incident surface of the light collector, the light collector can be disposed on the transparent substrate in tight contact with the transparent substrate. In the embodiments, the light collector 30 is formed exclusively of a plano-convex lens. However, it can be formed also of a plano-concave lens. Alternatively, as long as the light collector is located above the transparent substrate by using an appropriate section, it is also possible to use a bi-convex lens, a meniscus convex lens, a bi-concave lens, or a meniscus concave lens as the light collector.

The present disclosure contains subject matter related to that disclosed in Japanese Priority Patent Application JP 2010-109077 filed in the Japan Patent Office on May 11, 2010, the entire content of which is hereby incorporated by reference.

It should be understood by those skilled in the art that various modifications, combinations, sub-combinations and alterations may occur depending on design requirements and other factors insofar as they are within the scope of the appended claims or the equivalents thereof.

In so far as the embodiments of the invention described above are implemented, at least in part, using software-controlled data processing apparatus, it will be appreciated that a computer program providing such software control and a transmission, storage or other medium by which such a computer program is provided are envisaged as aspects of the present invention.

CLAUSES

Carious aspects of the invention are set out in the following numbered clauses:

1. A photoelectric conversion element comprising:

a first electrode;
a second electrode;
a photoelectric conversion layer disposed between the first electrode and the second electrode; and
a light collector configured to direct light incident on the light collector such that light incident on the second electrode is rendered uneven.

2. The photoelectric conversion element of clause 1, wherein the first electrode has a first current extraction region and the second electrode has a second current extraction region.

3. The photoelectric conversion element of clause 2, wherein a height of the light collector increases in a direction from the first current extraction region of the first electrode toward the second current extraction region of the second electrode.

4. The photoelectric conversion element of clause 2, wherein a height of the light collector decreases in a direction from the second current extraction region of the second electrode toward the first current extraction region of the first electrode.

5. The photoelectric conversion element of clause 2, wherein a height of the light collector increases in a direction from the second current extraction region of the second electrode toward the first current extraction region of the first electrode.

6. The photoelectric conversion element of clause 2, wherein a height of the light collector decreases in a direction from the first current extraction region of the first electrode toward the second current extraction region of the second electrode.

7. The photoelectric conversion element of clause 1, wherein an outer shape of the light collector includes a convex curvature.

8. The photoelectric conversion element of clause 1, wherein an outer shape of the light collector includes a concave curvature.

9. A photoelectric conversion device comprising:

a plurality of photoelectric conversion elements including a first photoelectric conversion element disposed adjacent to a second photoelectric conversion element, each photoelectric conversion element including
a first electrode having a first current extraction region,
a second electrode having a second current extraction region, and
a photoelectric conversion layer disposed between the first electrode and the second electrode; and
a light collector disposed adjacent to the plurality of photoelectric conversion elements;
wherein, for each photoelectric conversion element, the light collector is configured to direct light incident on the light collector toward the second current extraction region in an amount greater than the first current extraction region.

10. The photoelectric conversion device of clause 9, wherein an end portion of the second electrode of the first photoelectric conversion element is electrically connected to an end portion of the first electrode of the second photoelectric conversion element.

11. The photoelectric conversion device of clause 10, further comprising an interconnect portion that electrically connects the end portion of the second electrode of the first photoelectric conversion element with the end portion of the first electrode of the second photoelectric conversion element.

12. The photoelectric conversion device of clause 11, further comprising an adhesion layer disposed on either side of the interconnect portion.

13. The photoelectric conversion device of clause 9, wherein an end portion of the second electrode of the first photoelectric conversion element is insulated from an end portion of the second electrode of the second photoelectric conversion element.

14. The photoelectric conversion device of clause 13, further comprising an insulating layer disposed between the end portion of the second electrode of the first photoelectric conversion element and the end portion of the second electrode of the second photoelectric conversion element.

15. The photoelectric conversion device of clause 9, wherein the plurality of photoelectric conversion elements are arranged in a pattern comprising at least one of a C-character shape, an L-character shape, a lattice structure, a comb-shape structure or a structure combining a backbone electrode and a plurality of branch electrodes extending from the backbone electrode.

## Claims

1. A photoelectric conversion element comprising:

   a first electrode;
   a second electrode;
   a photoelectric conversion layer disposed between the first electrode and the second electrode; and
   a light collector configured to direct light incident on the light collector such that light incident on the second electrode is rendered uneven.

2. The photoelectric conversion element of claim 1, wherein the first electrode has a first current extraction region and the second electrode has a second current extraction region.

3. The photoelectric conversion element of claim 2, wherein the photoelectric conversion layer is configured to generate a plurality of free electrons such that a greater amount of free electrons are located in the second current extraction region of the second electrode than the first current extraction region of the first electrode.

4. The photoelectric conversion element of claim 1, wherein the second electrode has an electrical resistance greater than the first electrode.

5. The photoelectric conversion element of claim 2, wherein a height of the light collector increases in a direction from the first current extraction region of the first electrode toward the second current extraction region of the second electrode, or wherein a height of the light collector decreases in a direction from the second current extraction region of the second electrode toward the first current extraction region of the first electrode.

6. The photoelectric conversion element of claim 2, wherein a height of the light collector increases in a direction from the second current extraction region of the second electrode toward the first current extraction region of the first electrode, or wherein a height of the light collector decreases in a direction from the first current extraction region of the first electrode toward the second current extraction region of the second electrode.

7. The photoelectric conversion element of claim 1, wherein an outer shape of the light collector includes a convex curvature, or wherein an outer shape of the light collector includes a concave curvature.

8. A photoelectric conversion element comprising:

   a first electrode having a first current extraction region;
   a second electrode having a second current extraction region;
   a photoelectric conversion layer disposed between the first electrode and the second electrode; and

a light collector configured to direct light incident on the light collector toward the second current extraction region in an amount greater than the first current extraction region.

9. A photoelectric conversion device comprising:

a plurality of photoelectric conversion elements including a first photoelectric conversion element disposed adjacent to a second photoelectric conversion element, each photoelectric conversion element including

a first electrode having a first current extraction region,
a second electrode having a second current extraction region, and
a photoelectric conversion layer disposed between the first electrode and the second electrode; and

a light collector disposed adjacent to the plurality of photoelectric conversion elements;
wherein, for each photoelectric conversion element, the light collector is configured to direct light incident on the light collector toward the second current extraction region in an amount greater than the first current extraction region.

10. The photoelectric conversion device of claim 9, wherein an end portion of the second electrode of the first photoelectric conversion element is electrically connected to an end portion of the first electrode of the second photoelectric conversion element.

11. The photoelectric conversion device of claim 9, wherein an end portion of the second electrode of the first photoelectric conversion element is insulated from an end portion of the second electrode of the second photoelectric conversion element.

12. The photoelectric conversion device of claim 9, further comprising a gap between the first photoelectric conversion element and the second photoelectric conversion element.

13. The photoelectric conversion device of claim 12, wherein the light collector includes an extension region disposed above the gap configured such that light incident on the extension region of the light collector reaches an end portion of the second electrode of the first photoelectric conversion element.

14. The photoelectric conversion device of claim 9, wherein the first and second photoelectric conversion elements are arranged to have a mirror-image relationship.

15. A method of using a photoelectric conversion device, the method comprising:

providing a photoelectric conversion element including

a first electrode having a first current extraction region, and
a second electrode having a second current extraction region; and

directing light toward the photoelectric conversion element such that a greater amount of light is directed toward the second current extraction region than the first current extraction region.

# FIG.1A

# FIG.1B

# FIG. 2

# FIG.3A

# FIG.3B

# F I G . 4 A

# F I G . 4 B

# F I G . 5

# FIG.6A

11    22

# FIG.6B

24    21

11    23    22

# FIG.6C

24    21

26A    26B

11    23    22

# FIG. 7

# F I G . 8

# FIG.9A

26A   11        22        23              27A        26B

10        21        24              27B

# FIG.9B

11        22        23              27A

10        21        24              27B

# FIG.9C

11        22        23              27A

10        21        24              27B

# FIG.10

PHOTOELECTRIC
CONVERSION ⟺ PHOTOELECTRIC
CONVERSION
ELEMENT-B        ELEMENT-A

PHOTOELECTRIC
CONVERSION ⟺ PHOTOELECTRIC
CONVERSION
ELEMENT-A        ELEMENT-C

# FIG.11

# FIG.12

# F I G . 1 3

SIDE D              22A    21A

SIDE A    29    SIDE C  11       22

SIDE B

# FIG.14

# F I G . 1 5

# FIG.16

# FIG.17

# F I G . 1 8

RELATIVE POSITION OF INCIDENT LIGHT

EVEN INCIDENT LIGHT

LENS

OUTPUT LIGHT WITH LINEARLY INCLINED INTENSITY

RELATIVE POSITION OF OUTPUT LIGHT

# FIG.19

$$\tan \theta_i = \frac{h_i - h_{i+1}}{l}$$

$$\sin \theta_i = n_1 \sin \theta'_i$$

$$\tan(\theta_i - \theta'_i) = \frac{2(a_i - b_i)}{h_i + h_{i+1}}$$

$$n_1 \sin(\theta_i - \theta'_i) = n_2 \sin \theta''_i$$

$$\tan \theta''_i = \frac{b_i - c_i}{t}$$

$n_0 = 1$
$k_0 = 0$

$n_1, k_1$

$n_2, k_2$

# F I G . 2 0

**EP 2 387 080 A2**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003203681 A

- JP 2010109077 A